# EUROPÄISCHE PATENTSCHRIFT

(11) **EP 2 652 170 B1**
(45) Veröffentlichungstag und Bekanntmachung des Hinweises auf die Patenterteilung: **13.06.2018**
(21) Anmeldenummer: 11791507.4
(22) Anmeldetag: 23.11.2011
(51) Int. Cl.: C23C 18/14

(54) **VERFAHREN ZUR HERSTELLUNG VON METALLISCHEN STRUKTUREN**
METHOD FOR PRODUCING METAL STRUCTURES
PROCÉDÉ DE FABRICATION DE STRUCTURES MÉTALLIQUES

(30) Priorität: 23.11.2010 DE 102010052033
(43) Veröffentlichungstag der Anmeldung: 23.10.2013
(73) Patentinhaber: Leibniz-Institut für Neue Materialien gemeinnützige GmbH, 66123 Saarbrücken (DE)
(72) Erfinder: DE OLIVEIRA, Peter William, 66123 Saarbrücken (DE); MOH, Karsten, Dipl.-Phys., 66440 Blieskastel-Brenschelbach (DE); ARZT, Eduard, 66123 Saarbrücken (DE)
(74) Vertreter: Patentanwälte Gierlich & Pischitzis Partnerschaft mbB
(86) Internationale Anmeldenummer: PCT/EP2011/070861
(87) Internationale Veröffentlichungsnummer: WO 2012/069555

(56) Entgegenhaltungen:
- US-A1- 2009 269 510
- US-B1- 6 911 385
- GANG SHI ET AL: "Fabrication of TiO 2 Arrays Using Solvent-Assisted Soft Lithography", LANGMUIR, Bd. 25, Nr. 17, 1. September 2009 (2009-09-01), Seiten 9639-9643, XP55028852, ISSN: 0743-7463, DOI: 10.1021/la901662z
- EDWARD T. CASTELLANA ET AL: "Direct Writing of Metal Nanoparticle Films Inside Sealed Microfluidic Channels", ANALYTICAL CHEMISTRY, Bd. 78, Nr. 1, 1. Januar 2006 (2006-01-01) , Seiten 107-112, XP55028853, ISSN: 0003-2700, DOI: 10.1021/ac051288j

## Beschreibung

### Gebiet der Erfindung

Die Erfindung betrifft ein Verfahren zur Herstellung von metallischen, insbesondere leitfähigen Strukturen, sowie solche Substrate und ihre Verwendung.

### Stand der Technik

US 5,534,312 beschreibt eine Methode zur Herstellung einer metallischen Struktur durch Auftragen eines lichtempfindlichen Metallkomplexes auf ein Substrat und seine Zersetzung durch Bestrahlung. Dieses Verfahren ist kompliziert, da ein lichtempfindlicher Komplex gehandhabt werden muss. Außerdem entstehen üblicherweise Metalloxide, welche in einem weiteren Schritt mit Wasserstoff bei hohen Temperaturen von meistens über 200 °C zu den Metallen reduziert werden müssen.

Die Schrift US 2004/0026258 A1 beschreibt ein Verfahren, bei dem zunächst eine Mikrostruktur auf einem Substrat erzeugt wird. Diese Strukturen dienen als Keime für einen weiteren elektrolytischen Abscheidungsprozess. Auch in diesem Verfahren ist neben dem Abscheidungsprozess ein Reduktionsschritt erforderlich.

US 2005/0023957 A1 beschreibt die Herstellung einer eindimensionalen Nanostruktur. Dazu wird eine Beschichtung einer photokatalytischen Verbindung auf einem Substrat aufgetragen und durch eine Maske belichtet. Dadurch bilden sich in den belichteten Bereichen angeregte Zustände. Auf diesem latenten Bild werden dann Metalle elektrolytisch abgeschieden. Nachteilig an dieser Methode ist die kurze Lebensdauer des latenten Bilds, was eine sofortige Weiterbehandlung erfordert. Außerdem ist auch bei dieser Methode ein weiterer Abscheidungsschritt erforderlich, um leitfähige Strukturen zu erhalten.

In der Schrift US 2006/0144713 A1 wird auf die photokatalytische Verbindung ein Polymer aufgetragen, um die Lebensdauer der angeregten Zustände zu verlängern. Dies macht dieses Verfahren noch komplizierter. In den Publikationen Noh, C.-, et al., Advances in Resist Technology and Processing XXII, Proceedings of SPIE, 2005, 5753, 879-886, "A novel patterning method of low-resistivity metals" und Noh, C.-, et al., Chemistry Letters, 2005, 34(1), 82-83, "A novel patterning method of low-resistivity metals" wird beschrieben, dass auch die Verwendung einer Schicht aus amorphen Titandioxid als photokatalytische Schicht möglich ist. Allerdings konnte bei der Verwendung kristalliner Titandioxidnanopartikeln keine ausreichende Auflösung der Strukturen erreicht werden, wahrscheinlich aufgrund der Größe der Partikel, welche zu einer rauen Oberfläche führt. Aufgrund der geringeren photokatalytischen Aktivität von amorphem Titandioxid kann nur eine geringe Menge an Metall photokatalytisch abgeschieden werden.

In der Schrift US 2009/0269510 A1 wird die Herstellung von metallischen Filmen auf einer Beschichtung aus Titandioxidnanopartikeln beschrieben. Dazu werden sphärische Partikel mit einem Durchmesser zwischen 3 nm und 20 nm verwendet. Mit diesem Verfahren kann eine gewisse Strukturierung erreicht werden. Allerdings sind die Strukturen nicht transparent und weisen nur eine geringe Auflösung auf.

Die Publikation Jia, Huimin at al., Materials Research Bulletin, 2009, 44, 1312-1316, "Nonaqueous sol-gel synthesis and growth mechanism of single crystalline TiO2 nanorods with high photocatalytic activity" zeigt die Herstellung von Nanostäben aus Titandioxid.

In US 6,911,385 offenbart die Strukturierung einer Nanopartikeltinte auf einem Substrat mit Hilfe eines Stempels.

Alle Verfahren benötigen die Herstellung von Strukturen Masken für die Belichtung.

Es wäre von Vorteil, wenn es auch durch die photokatalytische Abscheidung die Herstellung von transparenten leitfähigen Strukturen möglich ist, was bisher meistens über ITO-Beschichtungen gelöst wird.

### Aufgabe

Aufgabe der Erfindung ist es, ein Verfahren anzugeben, das die Herstellung von metallischen Strukturen auf einfache Weise ermöglicht, insbesondere leitfähigen von Strukturen. Das Verfahren soll auch die Herstellung von transparenten Strukturen ermöglichen.

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht.

Die Aufgabe wird durch ein Verfahren zur Herstellung von metallischen Strukturen gelöst, wobei eine Initiatorzusammensetzung auf ein Substrat aufgetragen wird, wobei die Zusammensetzung als Initiator eine photokatalytisch aktive anorganische Substanz in Form von Nanostäben mit einem Durchmesser von unter 100 nm und einer Länge von unter 500 nm umfasst, unter Bildung einer Initiatorschicht. In einem weiteren Schritt wird auf das Substrat eine Vorläuferzusammensetzung umfassend eine Vorläuferverbindung für eine Metallschicht aufgetragen. Auf das Substrat wird eine Strukturvorlage auf die Initiatorschicht unter teilweiser Verdrängung der Vorläuferzusammensetzung aufgebracht. Durch die teilweise Verdrängung kommt es zum Kontakt zwischen der Strukturvorlage und der Oberfläche der Initiatorschicht.

Die Aufgabe wird auch durch ein Verfahren zur Herstellung von metallischen Strukturen gelöst, wobei eine Initiatorzusammensetzung auf ein Substrat aufgetragen wird, wobei die Zusammensetzung als Initiator eine photokatalytisch aktive anorganische Substanz umfasst, unter Bildung einer Initiatorschicht. In einem weiteren Schritt wird auf eine Strukturvorlage eine Vorläuferzusammensetzung umfassend eine Vorläuferverbindung für eine Metallschicht aufgebracht. Auf das Substrat wird die Vorläuferzusammensetzung zusammen mit der Strukturvorlage auf die Initiatorschicht unter teilweiser Verdrängung der Vorläuferzusammensetzung aufgebracht. Durch die teilweise Verdrängung kommt es zum Kontakt zwischen der Strukturvorlage und der Oberfläche der Initiatorschicht.

In einem weiteren Schritt wird die Vorläuferverbindung unter Einwirkung von elektromagnetischer Strahlung auf den Initiator zum Metall reduziert. Durch die teilweise Verdrängung geschieht dies nur dort, wo die Strukturvorlage die Vorläuferzusammensetzung und damit die Vorläuferverbindung nicht verdrängt hat. Dabei bildet sich üblicherweise eine Metallschicht. Hierbei wird unter einer metallischen Schicht im Sinne der Erfindung eine Schicht aus einem Metall verstanden. Solche Schichten können bei ausreichender Dicke auch leitfähig sein. Solche leitfähigen Schichten sind besonders bevorzugt. Dabei wird unter leitfähig nicht unbedingt die Herstellung von Strukturen verstanden, welche für sich eine Leiterbahn darstellen. Auch die Herstellung von Punkten aus leitfähigem Material stellt eine im Prinzip leitfähige Struktur dar.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Das beschriebene Verfahren hat den Vorteil, dass durch die gezielte Verdrängung der Vorläuferzusammensetzung auf einfache Weise eine Strukturierung erreicht werden kann. Solche Strukturvorlagen können auf einfache Weise hergestellt werden.

Das Substrat, das mit dem photokatalytischen Initiator beschichtet werden soll, kann jedes für diesen Zweck geeignete Material sein. Beispiele für geeignete Materialien sind Metalle oder Metalllegierungen, Glas, Keramik, einschließlich Oxidkeramik, Glaskeramik oder Kunststoffe, sowie Papier und andere zellulosehaltige Materialien. Selbstverständlich sind auch Substrate verwendbar, die eine Oberflächenschicht aus den vorstehend genannten Materialien aufweisen. Bei der Oberflächenschicht kann es sich z.B. um eine Metallisierung, eine Emaillierung, eine Glas- oder Keramikschicht oder eine Lackierung handeln.

Beispiele für Metalle oder Metalllegierungen sind Stahl, einschließlich Edelstahl, Chrom, Kupfer, Titan, Zinn, Zink, Messing und Aluminium. Beispiele für Glas sind Natronkalkglas, Borosilikatglas, Bleikristall und Kieselglas. Es kann sich z.B. um Flachglas, Hohlglas wie Behälterglas, oder um Laborgeräteglas handeln. Bei der Keramik handelt es sich z.B. um eine Keramik auf Basis der Oxide SiO₂, Al₂O₃, ZrO₂ oder MgO oder der entsprechenden Mischoxide. Beispiele für den Kunststoff, der, wie auch das Metall, als Folie vorliegen kann, sind Polyethylen (PET), z.B. HDPE oder LDPE, Polypropylen, Polyisobutylen, Polystyrol (PS), Polyvinylchlorid (PVC), Polyvinylidenchlorid, Polyvinylbutyral, Polytetrafluorethylen, Polychlortrifluorethylen, Polyacrylate, Polymethacrylate wie Polymethylmethacrylat (PMMA), Polyamid, Polyethylenterephthalat, Polycarbonat, regenerierte Cellulose, Cellulosenitrat,
Celluloseacetat, Cellulosetriacetat (TAC), Celluloseacetatbutyrat oder Kautschuk-Hydrochlorid. Eine lackierte Oberfläche kann aus üblichen Grundanstrichen oder Lacken gebildet sein. In einer bevorzugten Ausführungsform sind die Substrate Folien, insbesondere Polyethylenterephthalatfolien oder Polyimidfolien.

Die Initiatorzusammensetzung beinhaltet als Initiator eine photokatalytisch aktive anorganische Substanz. Dabei wird unter photokatalytische aktiver Substanz eine Verbindung verstanden, welche die Reduktion eines Metallions in einem Metallkomplex zum Metall direkt und/oder durch oxidative Aktivierung des Metallkomplexes oder einer weiteren Substanz indirekt bewirkt, ohne dabei selbst zersetzt zu werden. Durch die bei der Oxidation entstehenden Produkte kommt es zu einer Zersetzung des Metallkomplexes und Reduktion des Metallions des Komplexes. Bei dem photokatalytischen Material kann es sich um ZnO oder TiO₂ handeln, wobei TiO₂ bevorzugt ist. Besonders bevorzugt liegt das TiO₂ als Anatas vor.

Das TiO₂ kann auch als amorphes TiO₂ vorliegen. Bevorzugt handelt es sich Stäbe aus TiO₂.
Die Initiatorzusammensetzung umfasst Nanostäbe. Im Sinne der Erfindung werden darunter im Allgemeinen längliche Körper verstanden, im Gegensatz zu sphärischen Nanopartikeln. Ein solcher stabförmiger Körper lässt sich beispielsweise anhand von zwei Parametern beschreiben. Zum einen der Durchmesser des Stabs und zum anderen die Länge des Stabs. Nanostäbe zeichnen sich dadurch aus, dass sie einen Durchmesser von unter 100 nm, bevorzugt unter 50 nm, bevorzugt unter 40 nm, besonders bevorzugt unter 30 nm aufweisen. Ihre Länge liegt dabei unter 500 nm, bevorzugt unter 400 nm, besonders bevorzugt unter 200 nm. Die Dimensionen können mittels TEM ermittelt werden. Die Nanostäbe liegen in TEM meistens auf der längeren Seite. Die bestimmten Durchmesser stellen daher einen Durchschnitt der Durchmesser von Nanostäben unterschiedlicher Orientierung dar. In der Zusammensetzung können auch Agglomerate von Nanostäben auftreten. Die Angaben beziehen sich immer auf ein Nanostäbchen.

In einer bevorzugten Ausführungsform weisen die Nanostäbe ein Verhältnis von Länge zu Durchmesser ein Verhältnis zwischen 1000:1 und 1,5:1 auf, bevorzugt zwischen 500:1 und 2:1, besonders bevorzugt zwischen 100:1 und 5:1.

In einer bevorzugten Ausführungsform weisen die Nanostäbe eine Länge zwischen 30 und 100 nm auf, bei einem Verhältnis von Länge zu Durchmesser von zwischen 10:1 und 3:1.

Durch ihre längliche Ausdehnung besitzen die Nanostäbe eine besonders hohe photokatalytische Aktivität.

Zur Herstellung der Nanostäbe kommen alle dem Fachmann bekannten Verfahren in Betracht. Dies sind beispielsweise hydrolytische oder nicht hydrolytische Sol-Gel-Verfahren. Für solche Verfahren sind Bedingungen bekannt unter denen Nanostäbe erhalten werden.

Die Nanostäbe werden bevorzugt durch einen nicht hydrolytischen Sol-Gel-Prozess hergestellt. Dazu wird eine hydrolysierbare Titanverbindung und/oder Zinkverbindung mit einem Alkohol oder einer Karbonsäure umgesetzt, bevorzugt unter Schutzgasathmosphäre. Die Reaktion wird bevorzugt bei Temperaturen zwischen 10 °C und 100 °C, bevorzugt zwischen 15 °C und 30 °C durchgeführt. In einer Ausführungsform kann die Umsetzung bei Raumtemperatur durchgeführt werden.

Bei der hydrolysierbaren Titanverbindung handelt es sich insbesondere um eine Verbindung der Formel TiX₄, wobei die hydrolysierbaren Gruppen X, die verschieden voneinander oder vorzugsweise gleich sind, beispielsweise Wasserstoff, Halogen (F, Cl, Br oder I, insbesondere Cl und Br), Alkoxy (vorzugsweise C₁₋₆-Alkoxy, insbesondere C₁₋₄-Alkoxy, wie z.B. Methoxy, Ethoxy, n-Propoxy, i-Propoxy, Butoxy, i-Butoxy, sek.-Butoxy und tert.-Butoxy), Aryloxy (vorzugsweise C₆₋₁₀-Aryloxy, wie z.B. Phenoxy), Acyloxy (vorzugsweise C₁₋₆-Acyloxy, wie z.B. Acetoxy oder Propionyloxy) oder Alkylcarbonyl (vorzugsweise C₂₋₇-Alkylcarbonyl, wie z.B. Acetyl) sind. Ein Beispiel für ein Halogenid ist TiCl₄. Weitere hydrolysierbare Reste X sind Alkoxygruppen, insbesondere C₁₋₄-Alkoxy. Konkrete Titanate sind Ti(OCH₃)₄, Ti(C)C₂H₅)₄ und Ti(n- oder i-OC₃H₇)₄. Bevorzugt ist TiCl₄.

Im Falle einer Zinkverbindung kommen Karbonsäureverbindung des Zinks in Betracht, beispielsweise Zn(OAc)₂.

Bei dem Alkohol oder der Karbonsäure handelt es sich in der Regel um niedere Alkohole oder Karbonsäuren. Beispiele für solche Verbindung sind Alkylalkohole, wie Methanol, Ethanol, n-Propanol, i-Propanol, n-Butanol, i-Butanol, Neopentanol, Glykol, 1,3-Propandiol oder Benzylalkohole, wie Benzylalkohol, welche auch am Aromaten substituiert sein können. Beispile für Karbonsäuren umfassen beispielsweise Ameisensäure, Essigsäure, Propionsäure, Buttersäure, Oxalsäure. Es können auch Mischungen der Lösungsmittel eingesetzt werden. Bevorzugt ist die Verwendung von Benzylalkohol. Die Verbindung wird bevorzugt auch als Lösungsmittel eingesetzt, d.h. im deutlichen Überschuss.

Um kristalline Nanostäbe zu erhalten, kann es erforderlich sein, noch eine Wärmebehandlung, bevorzugt eine Wärmebehandlung unter autogenem Druck durchzuführen. Dazu wird die Reaktionsmischung in einem geschlossenen Behälter bei einer Temperatur zwischen 50 °C und 300 °C, bevorzugt zwischen 50 °C und 100 °C für 2 Stunden bis 48 Stunden behandelt.

Die erhaltenen Nanostäbe können durch einfache Zentrifugation und Entfernung des Lösungsmittels gewonnen werden.

Die Nanostäbe können auch dotiert sein, beispielsweise um ihre Absorption in andere Spektralbereiche zu verschieben.

Dazu kann bei den Nanostäben bei ihrer Herstellung eine geeignete Metallverbindung zur Dotierung eingesetzt werden, z.B. ein Oxid, ein Salz oder eine Komplexverbindung, z.B. Halogenide, Nitrate, Sulfate, Carboxylate (z.B. Acetate) oder Acetylacetonate. Die Verbindung sollte in dem für die Herstellung der Nanostäbe verwendeten Lösungsmittel zweckmäßigerweise löslich sein. Als Metall eignet sich jedes Metall, insbesondere ein Metall ausgewählt aus der 5. bis 14. Gruppe des Periodensystems der Elemente und der Lanthanoiden und Actiniden. Die Gruppen werden hier entsprechend dem neuen TLTPAC-System aufgeführt, wie es in Römpp Chemie Lexikon, 9. Auflage, wiedergegeben ist. Das Metall kann in der Verbindung in jeder geeigneten Oxidationsvorstufe vorkommen.

Beispiele für geeignete Metalle für die Metallverbindung sind W, Mo, Zn, Cu, Ag, Au, Sn, In, Fe, Co, Ni, Mn, Ru, V, Nb, Ir, Rh, Os, Pd und Pt. Metallverbindungen von W(VI), Mo(VI), Zn(II), Cu(II), Au(III), Sn(IV), In(III), Fe(III), Co(II), V(V) und Pt(IV) werden bevorzugt verwendet. Sehr gute Ergebnisse werden insbesondere mit W(VI), Mo(VI), Zn(II), Cu(II), Sn(IV), In(III) und Fe(III) erreicht. Konkrete Beispiele für bevorzugte Metallverbindungen sind WO₃, MoO₃, FeCl₃, Silberacetat, Zinkchlorid, Kupfer(II)-chlorid, Indium(III)-oxid und Zinn(IV)-acetat.

Das Mengenverhältnis zwischen der Metallverbindung und der Titan- oder Zinkverbindung hängt auch von dem eingesetzten Metall und dessen Oxidationsstufe ab. Im Allgemeinen werden z.B. solche Mengenverhältnisse eingesetzt, dass sich ein Molverhältnis von Metall der Metallverbindung zu Titan/Zink der Titan- oder Zinkverbindung (Me/Ti(Zn)) von 0,0005:1 bis 0,2:1, bevorzugt 0,001:1 bis 0,1:1 und bevorzugter 0,005:1 bis 0,1:1 ergibt.

Die Dotierung von Nanopartikeln ist in US 2009/0269510 A1 beschrieben, deren Inhalt hiermit zum Gegenstand der Beschreibung gemacht wird. Im Wesentlichen wird auch dort eine vorstehend genannte Metallverbindung während der Herstellung zugegeben.

Die erhaltenen Nanostäbe können auch oberflächenmodifiziert werden, beispielsweise um ihnen eine Kompatibilität mit dem verwendeten Matrixmaterial zu verleihen. Außerdem ist es, beispielsweise durch die Oberflächenmodifikation mit fluorierten Gruppen möglich, einen Konzentrationsgradienten der Nanostäbe innerhalb der Initiatorschicht zu erreichen. Die Nanostäbe lagern sich an der nach dem Auftragen freien Oberfläche der Initiatorschicht an und können bei der Bestrahlung das Substrat nicht schädigen.

Bei der Initiatorzusammensetzung handelt es sich in der Regel um eine Dispersion der Nanostäbe in mindestens einem Lösungsmittel. Der Anteil der Nanostäbe beträgt dabei unter 20 Gew.-%, bevorzugt unter 10 Gew.-%, besonders bevorzugt unter 5 Gew.-%. Ein bevorzugter Bereich liegt zwischen 0,5 Gew.-% und 3 Gew.-%. Beispiele sind 1 Gew.-%, 1,5 Gew.-%, 2 Gew.-% und 2,5 Gew.-%. Dabei bezieht sich der Anteil auf die Initiatorzusammensetzung.

Als Lösungsmittel eignen sich dem Fachmann bekannte Lösungsmittel für Nanopartikel. Bevorzugt sind Lösungsmittel, welche einen Siedepunkt von unter 150 °C aufweisen. Beispiele hierfür sind deionisiertes H₂O, Methanol, Ethanol, Isopropanol, n-Propanol oder Butanol. Es können auch Mischungen eingesetzt werden. Beispiele für solche Mischungen sind H₂O : Alkohol zwischen 80:20 Gew.-% und 20:80 Gew.-%, bevorzugt 50:50 Gew.-% bis 20:80 Gew.-%, wobei als Alkohol bevorzugt Ethanol verwendet wird.

Zum Aufbringen der Initiatorzusammensetzung können übliche Verfahren verwendet werden, beispielsweise Tauchen, Rollen, Rakeln, Fluten, Ziehen, Spritzen, Schleudern oder Aufstreichen. Die aufgebrachte Dispersion wird gegebenenfalls getrocknet und wärmebehandelt, etwa zur Härtung oder Verdichtung. Die dafür verwendete Wärmebehandlung hängt natürlich vom Substrat ab. Bei Kunststoffsubstraten oder Kunststoffoberflächen, die in der Regel eine Sperrschicht aufweisen (siehe nachstehend), können naturgemäß keine sehr hohen Temperaturen verwendet werden. So werden Polycarbonat (PC)-Substrate z.B. bei etwa 130 °C für 1 h wärmebehandelt. Allgemein erfolgt die Wärmebehandlung z.B. bei einer Temperatur von 100 bis 200 °C und, sofern kein Kunststoff vorhanden ist, bis zu 500 °C oder mehr. Die Wärmebehandlung erfolgt z.B. 2 min bis 2 h.

Es können Schichten von unterschiedlicher Dicke erhalten werden. So können Schichten mit einer Dicke zwischen 5 nm bis 200 µm erhalten werden. Bevorzugte Schichtdicken liegen zwischen 10 nm und 1 µm, bevorzugt 50 nm bis 700 nm. Die Schichtdicke kann aber auch zwischen 20 µm und 70 µm liegen.

In einem nächsten Schritt wird eine Vorläuferzusammensetzung umfassend mindestens eine Vorläuferverbindung für eine Metallschicht auf das Substrat aufgetragen. Zum Aufbringen der Vorläuferzusammensetzung können übliche Verfahren verwendet werden, beispielsweise Tauchen, Rollen, Rakeln, Fluten, Ziehen, Spritzen, Schleudern oder Aufstreichen. Üblicherweise ist die Vorläuferzusammensetzung eine Lösung oder Suspension der mindestens einen Vorläuferverbindung. Diese Lösung kann auch ein Gemisch aus mehreren Vorläuferverbindungen enthalten. Auch können weitere Hilfsstoffe, wie Reduktionsmittel oder Benetzungshilfsmittel in der Lösung enthalten sein.

Bei der Vorläuferverbindung handelt es sich bevorzugt um einen Metallkomplex. Dieser umfasst mindestens ein Metallion oder ein Metallatom und mindestens eine Art von Liganden. Bei dem Metall handelt es sich beispielsweise um Kupfer, Silber, Gold, Nickel, Zink, Aluminium, Titan, Chrom, Mangan, Wolfram, Platin oder Palladium. In einer bevorzugten Ausführungsform ist die Vorläuferverbindung ein Silber-, Gold- oder Kupferkomplex, besonders bevorzugt ein Silberkomplex. Die Vorläuferverbindung kann auch mehrere Arten von Metall oder Mischungen von Metallkomplexen umfassen.

Als Ligand werden in der Regel Chelatliganden eingesetzt. Diese sind in der Lage besonders stabile Komplexe zu bilden. Dabei handelt es sich um Verbindungen, welche mehrere Hydroxylgruppen und/oder Aminogruppen aufweisen. Bevorzugt sind Verbindungen mit einem Molekulargewicht von unter 200 g/mol, besonders bevorzugt Verbindungen mit mindestens einer Hydroxylgruppe und mindestens einer Aminogruppe. Beispiele für mögliche Verbindungen sind 3-Amino-1,2-propandiol, 2-Amino-1-butanol, Tris(hydroxymethyl)-aminomethan (TRIS), NH₃, Nikotinamid oder 6-Aminohexansäure. Es können auch Mischungen dieser Liganden verwendet werden. Im Falle des bevorzugten Silberkomplexes ist als Ligand TRIS bevorzugt.

Die Vorläuferzusammensetzung ist bevorzugt eine Lösung der Vorläuferverbindung. Als Lösungsmittel kommen alle geeigneten Lösungsmittel in Betracht. Dies sind beispielsweise Wasser, Alkohole, wie Methanol, Ethanol, n-Propanol oder i-Propanol. Es können auch Mischungen der Lösungsmittel verwendet werden, bevorzugt Mischungen von Wasser und Ethanol. Als Mischungsverhältnis ist ein Verhältnis von 50:50 Gew.-% bis zu 20:80 Gew.-% von H₂O:Alkohol, bevorzugt Ethanol, geeignet.

Die Vorläuferzusammensetzung kann zusätzlich noch weitere Hilfsmittel, wie Tenside oder unterstützende Reduktionsmittel enthalten.

Die Vorläuferzusammensetzung kann auf beliebige Weise auf das Substrat aufgetragen werden. Dabei wird die Vorläuferzusammensetzung so aufgetragen, dass durch die photokatalytische Aktivität der Initiatorschicht direkt oder indirekt die Reduktion des Metallions zum Metall ausgelöst werden kann. Üblicherweise geschieht dies dadurch, dass die Vorläuferzusammensetzung direkt auf die Initiatorschicht aufgetragen wird.

Zum Aufbringen der Vorläuferzusammensetzung können übliche Verfahren verwendet werden, beispielsweise Tauchen, Sprühen, Rollen, Rakeln, Fluten, Ziehen, Spritzen, Schleudern oder Aufstreichen.

Beispielsweise kann das Auftragen der Vorläuferzusammensetzung über einen Rahmen, welcher auf das Substrat gelegt wird und in den dann gebildeten durch den Rahmen begrenzten Raum die Vorläuferzusammensetzung gegeben wird. Der Rahmen kann aus einem elastischen Material bestehen. Der Rahmen kann beliebige Formen aufweisen. Üblicherweise ist es ein rechteckiger Rahmen. Der Rahmen umschließt dabei beispielsweise eine Fläche auf dem Substrat von zwischen 1 cm² bis 625 cm² bei einer Seitenlänge zwischen 1 cm und 25 cm. Die Höhe des Rahmens auf dem Substrat bestimmt dabei die Dicke der aufgetragenen Vorläuferzusammensetzung. Der Rahmen kann dabei zwischen 25 µm und 5 mm hoch sein, bevorzugt zwischen 30 µm und 2 mm.

In einem weiteren Schritt wird aus die Initiatorschicht eine Strukturvorlage unter teilweiser Verdrängung der Vorläuferzusammensetzung aufgebracht. Bei der Strukturvorlage handelt es sich um eine beliebig geformte Vorlage, welche durch in Kontakt treten mit der Oberfläche der Initiatorschicht an diesen Stellen die Vorläuferzusammensetzung verdrängt. Dabei muss die Vorläuferzusammensetzung auf der Oberfläche der Initiatorschicht so viskos oder flüssig sein, dass es zu einer Verdrängung kommen kann.

Die Strukturvorlage kann beispielsweise ein Stempel oder ein Sieb sein. Die Strukturvorlage kann aus beliebigen Materialien geformt sein. Dabei ist zu beachten, dass eine Bestrahlung der Initiatorschicht und damit auch die Reduktion der Vorläuferverbindung auch noch nach dem Aufbringen der Strukturvorlage auf dem Substrat möglich sein müssen. Falls die Strukturvorlage nicht durchlässig für die verwendete Strahlung ist, kann es nötig sein, die Bestrahlung durch das Substrat hindurch durchzuführen. Bevorzugt ist die Strukturvorlage zumindest an den Vertiefungen, in welche die Vorläuferzusammensetzung beim Aufbringen gedrückt wird, für die verwendete Strahlung durchlässig.

Mögliche Materialien für die Strukturvorlage sind dem Fachmann aus dem Bereicht der Mikrostrukturstempel bekannt. Sie können beispielsweise auch mit lithographischen erhalten werden. Beispiele sind Metalle, wie Nickel, Halbmetalle wie Silizium oder Photolacke. Es können auch Silikone wie PDMS (Polydimethylsiloxan) verwendet werden.

Mit Vorteil ist die Strukturvorlage aus einem Material, welches für die verwendete elektromagnetische Strahlung durchlässig ist, bevorzugt PDMS.

Es kann erforderlich sein, die Oberfläche der Strukturvorlage zu behandeln, beispielsweise durch Behandlung mit fluorierten Silanen.

Es kann notwendig sein, die Ausbildung der Strukturvorlage an die Dicke der Schicht der Vorläuferzusammensetzung anzupassen, beispielsweise um genügend Raum für die verdrängte Vorläuferverbindung sowie eingeschlossene Luft bereitzustellen. Ebenso kann dies durch die Dicke der Strukturvorlage, beziehungsweise durch die Tiefer der auf ihrer Oberfläche vorhandenen Vertiefungen, beeinflusst werden.

Die Strukturvorlage stellt bezogen auf die durch sie kontaktierte Fläche ein Negativ der gewünschten metallischen Struktur dar.

Es ist auch möglich, dass die Vorläuferzusammensetzung zuerst auf die Strukturvorlage aufgebracht wird und beides zusammen auf die Initiatorschicht aufgebracht wird.

In einem nächsten Schritt wird das Metallion der Vorläuferverbindung durch Einwirkung von elektromagnetischer Strahlung auf den Initiator zum Metall reduziert. Dabei bildet sich eine metallische Schicht. Bei der elektromagnetischen Strahlung handelt es sich um Strahlung der Wellenlänge zur Anregung des Initiators. Dabei kann die Bestrahlung durch Verwendung einer flächigen Strahlungsquelle, wie einer Lampe, oder durch Laser geschehen. Bevorzugt wird eine Wellenlänge im sichtbaren oder ultravioletten Bereich des elektromagnetischen Spektrums verwendet, bevorzugt Strahlung mit einer Wellenlänge von < 500 nm, beispielsweise zwischen 200 nm und 450 nm oder zwischen 210 nm und 410 nm. Bevorzugt ist es Strahlung mit einer Wellenlänge von < 400 nm.

Als Lichtquelle kann jede geeignete Lichtquelle verwendet werden. Beispiele für eine Lichtquelle sind Quecksilberdampflampen oder Xenonlampen.

Die Lichtquelle ist in geeignetem Abstand zu dem zu belichtenden Substrat angeordnet. Der Abstand kann dabei beispielsweise zwischen 2,5 cm und 50 cm betragen. Die Intensität der Strahlung kann dabei in einem Spektralbereich von 250 nm bis 410 nm zwischen 30 mW/cm² und 70 mW/cm² liegen.

Die Bestrahlung sollte möglichst senkrecht zur zu belichtenden Oberfläche erfolgen.

Die Bestrahlung wird in der zur Bildung der metallischen Schicht ausreichenden Dauer durchgeführt. Die Dauer hängt dabei von der Beschichtung, der Art des Initiators, der Art der Lampe, des verwendeten Wellenlängenbereichs und der Intensität der Bestrahlung ab. Falls leitfähige Strukturen erzeugt werden sollen, kann eine längere Bestrahlung erforderlich sein. Bevorzugt ist eine Dauer der Bestrahlung zwischen 5 Sekunden und 10 Minuten, bevorzugt zwischen 20 Sekunden und 4 Minuten.

Falls zur Bestrahlung ein Laser verwendet wird, kann beispielsweise ein Argon-Ionen-Laser (351 nm) mit 10 mW eingesetzt werden, dessen Laserstrahl fokussiert und kollimiert und mit einer Geschwindigkeit von 2 mm/s über das zu bestrahlende Substrat geführt wird.

Die Bestrahlung kann soweit möglich von der Seite der Strukturvorlage oder durch das Substrat hindurch erfolgen. Bevorzugt ist die Bestrahlung durch die Strukturvorlage.

Nach der Bestrahlung wird die Strukturvorlage entfernt.

In einer weiteren Ausführungsform der Erfindung wird das Substrat nach der Bestrahlung und Reduktion der Vorläuferverbindung weiter behandelt. So kann beispielsweise die nicht reduzierte überschüssige Vorläuferzusammensetzung durch Spülen der Oberfläche entfernt werden, beispielsweise mit deionisiertem Wasser oder einer anderen geeigneten Substanz. Das beschichtete Substrat kann danach getrocknet werden, beispielsweise durch Erwärmen in einem Ofen, Druckluft und/oder durch Trocknen bei Raumtemperatur.

Es können auch noch weitere Schichten, beispielsweise zum Schutz der beschichteten Oberfläche vor Oxidation und Wasser oder vor UV-Strahlung aufgebracht werden.

In einer Ausführungsform der Erfindung erfolgt beim Auftragen der Vorläuferzusammensetzung und/oder bei der Reduktion zusätzlich eine Strukturierung. Darunter wird im Sinne der Erfindung eine Vorbereitung der räumlich begrenzten Erzeugung der metallischen Struktur verstanden. Dies ist auf unterschiedliche Weise möglich. Zum einen kann das Substrat nur in bestimmten Bereichen mit der Initiatorzusammensetzung beschichtet werden. Außerdem ist es möglich, die Vorläuferzusammensetzung nur auf bestimmte Bereiche aufzubringen. Desweiteren kann natürlich auch die Einwirkung der elektromagnetischen Strahlung auf bestimmte Bereiche begrenzt werden. Diese Verfahren können natürlich auch in Kombination verwendet werden. So ist es beispielsweise möglich, die Vorläuferzusammensetzung flächig aufzubringen und dann durch eine Maske zu belichten. Es ist natürlich ebenso möglich, die Vorläuferzusammensetzung gezielt aufzubringen und danach flächig zu belichten.

Für die Qualität der erhaltenen Strukturen spielt neben der photokatalytischen Aktivität des Initiators auch die Qualität, beispielsweise die Benetzungsfähigkeit oder Rauheit, der Initiatorschicht in Bezug auf die Vorläuferzusammensetzung eine Rolle. Gerade die erfindungsgemäßen Initiatorzusammensetzungen zeichnen sich dadurch aus, dass auf ihnen ein gezieltes Auftragen der Vorläuferzusammensetzung und/oder eine sehr gezielte Reduktion der Vorläuferverbindung möglich sind.

In einer bevorzugten Ausführungsform der Erfindung, umfasst die Strukturierung Strukturen mit einer minimalen lateralen Ausdehnung von unter 500 µm. Dies bedeutet, dass die hergestellten Strukturen auf dem Substrat eine minimale Breite von 500 µm aufweisen, bevorzugt ist eine Ausdehnung von unter 100 µm, 50 µm, 20 µm, besonders bevorzugt 10 µm. Es sind sogar Strukturen von unter 5 µm oder unter 1 µm möglich.

Für die erzielte Auflösung der metallischen Strukturen, d.h. der Ausbildung der Metallschicht, ist die Struktur der gebildeten photokatalytischen Schicht von Bedeutung. Neben der Verwendung der Nanostäbe ist es möglich, die erzielte Auflösung durch eine Vorbehandlung des Substrats zu erreichen. Eine solche Vorbehandlung kann auch das Aufbringen einer weiteren Schicht bedeuten.

In einer bevorzugten Weiterbildung der Erfindung umfasst die Vorbehandlung eine Plasmabehandlung, Koronabehandlung, Flammenbehandlung und/oder das Auftragen und Härten einer organisch-anorganischen Beschichtung. Eine Plasmabehandlung, Koronabehandlung und/oder Flammenbehandlung kommt insbesondere bei Foliensubstraten, insbesondere bei Kunststofffolien in Betracht. Dabei wurde gefunden, dass eine solche Behandlung die Qualität der erhaltenen photokatalytischen Schicht verbessert.

Mögliche Wege zum Erhalt von Plasma unter Vakuumbedingungen sind in der Literatur häufig beschrieben worden. Die elektrische Energie kann durch induktive oder kapazitive Mittel verknüpft werden. Sie kann Gleichstrom oder Wechselstrom sein; die Frequenz des Wechselstroms kann von einigen kHz bis in den MHz-Bereich reichen. Eine Energiezufuhr im Mikrowellenbereich (GHz) ist auch möglich.

Als primäre Plasmagase können beispielsweise He, Argon, Xenon, N₂, O₂, H₂, Dampf oder Luft, und ebenso Gemische aus diesen Verbindungen verwendet werden. Bevorzugt ist ein Sauerstoffplasma.

Üblicherweise werden die Substrate vorher gesäubert. Dies kann durch einfaches Abspülen mit einem Lösungsmittel geschehen. Die Substrate werden danach gegebenenfalls getrocknet und dann für unter 5 Minuten mit Plasma behandelt. Die Behandlungsdauer kann von der Empfindlichkeit des Substrats abhängen. Üblicherweise beträgt sie zwischen 1 und 4 Minuten.

Eine weitere Möglichkeit die Qualität der photokatalytischen Schicht zu verbessern, ist die vorherige Flammenbehandlung der Oberfläche. Eine solche Behandlung ist dem Fachmann bekannt. Die auszuwählenden Parameter werden durch das bestimmte zu behandelnde Substrat vorgegeben. Beispielsweise werden die Flammentemperaturen, die Flammenintensität, die Verweilzeiten, der Abstand zwischen Substrat und Ofen, das Wesen des Verbrennungsgases, Luftdruck, Feuchtigkeit, auf das in Frage stehende Substrat abgestimmt. Als Flammengase können beispielsweise Methan, Propan, Butan oder ein Gemisch aus 70 % Butan und 30 % Propan verwendet werden. Auch diese Behandlung findet bevorzugt bei Folien, besonders bevorzugt bei Kunststofffolien Anwendung.

In einer weiteren Ausführungsform der Erfindung enthält die Initiatorzusammensetzung eine Verbindung mit mindestens 2 polaren Gruppen. Bevorzugt sind dies organische Verbindungen. Unter polaren Gruppen werden Gruppen verstanden, welche O, N, oder S enthalten. Bevorzugt sind es Verbindungen, welche mindestens 2 OH, NH₂, NH oder SH-Gruppen enthalten. Solche Verbindungen können zu einer Verbesserung der erhaltenen Initiatorschicht führen. Beispiele für solche Verbindungen sind Oligomere von Verbindungen, wie 1,2-Ethandiol, 1,3-Propandiol, 1,4-Butandiol, 1,2-Ethylendiamin, 1,3-Propandiamin, 1,4-Butandiamin, welche jeweils über ein Sauerstoff, Stickstoff oder Schwefelatom verknüpft sind. Dabei bestehen Oligomere aus 2 bis 4 der vorstehend genannten Verbindungen. Beispiele sind Monoethylenglykol (MEG), Diethylenglykol (DEG), Triethylenglykol.

Die Verbindung wird bevorzugt in Anteilen von unter 10 Gew.-% bezogen auf die Masse der Suspension an Nanostäben, bevorzugt unter 5 Gew.-%, besonders bevorzugt zwischen 1 bis 4 Gew.-% eingesetzt.

In einer bevorzugten Ausführungsform umfasst die Initiatorzusammensetzung ein anorganisches oder organisch modifiziertes anorganisches matrixbildendes Material. Hierbei kann es sich insbesondere um anorganische Sole oder organisch modifizierte anorganische Hybridmaterialien oder Nanokomposite handeln. Beispiele hierfür sind gegebenenfalls organisch modifizierte Oxide, Hydrolysate und (Poly)Kondensate von mindestens einem glas- oder keramikbildenden Element M, insbesondere einem Element M aus den Gruppen 3 bis 5 und/oder 12 bis 15 des Periodensystems der Elemente, bevorzugt von Si, Al, B, Ge, Pb, Sn, Ti, Zr, V und Zn, insbesondere solche von Si und Al, am meisten bevorzugt Si, oder Mischungen davon. Es können auch anteilig Elemente der Gruppen 1 und 2 des Periodensystems (z.B. Na, K, Ca und Mg) und der Gruppen 5 bis 10 des Periodensystems (z.B. Mn, Cr, Fe und Ni) oder Lanthanoiden im Oxid, Hydrolysat oder (Poly)Kondensat vorhanden sein. Ein bevorzugtes organisch modifiziertes anorganisches Hybridmaterial sind Polyorganosiloxane. Besonders bevorzugt werden hierfür Hydrolysate von glas- oder keramikbildenden Elementen, insbesondere von Silizium verwendet.

Das anorganische oder organisch-modifizierte anorganische matrixbildende Material wird bevorzugt in einer solchen Menge zugegeben, dass das Verhältnis zwischen der photokatalytisch aktiven Substanz und dem matrixbildenden Material bezogen in Gew.-% der gesamten Zusammensetzung zwischen 300:1 bis 1:300 beträgt, bevorzugt zwischen etwa 30:1 bis 1:30, besonders bevorzugt zwischen 1:20 und 1:2.

Im Fall von lyothermal hergestellten Titannanopartikeln wird das organisch-modifizierte anorganische matrixbildende Material bevorzugt in einer solchen Menge zugegeben, dass das Molverhältnis von Titan der Titanverbindung zu glas- oder keramikbildendem Element M 100:0,01 bis 0,01:100, vorzugsweise 300:1 bis 1:300 beträgt. Sehr gute Ergebnisse werden bei einem Molverhältnis Ti/M von etwa 10:3 bis 1:30 erhalten.

Durch diese Zugabe wird eine Verbesserung der Haftung erreicht. Sofern ein organisch-modifiziertes anorganisches matrixbildendes Material verwendet wird, können alle oder nur ein Teil der enthaltenen glas- oder keramikbildenden Elemente M eine oder mehrere organische Gruppen als nicht hydrolysierbare Gruppen aufweisen.

Die anorganischen oder organisch modifizierten anorganischen matrixbildenden Materialien können nach bekannten Verfahren hergestellt werden, z.B. durch Flammpyrolyse, Plasmaverfahren, Gasphasenkondensationsverfahren, Kolloidtechniken, Präzipitationsverfahren, Sol-Gel-Verfahren, kontrollierte Nukleations- und Wachstumsprozesse, MOCVD-Verfahren und (Mikro)emulsions-verfahren.

Vorzugsweise werden die anorganischen Sole und insbesondere die organisch-modifizierten Hybridmaterialien nach dem Sol-Gel-Verfahren erhalten. Beim Sol-Gel-Verfahren, das auch zur gesonderten Herstellung der Teilchen verwendet werden kann, werden gewöhnlich hydrolysierbare Verbindungen mit Wasser, gegebenenfalls unter saurer oder basischer Katalyse, hydrolysiert und gegebenenfalls zumindest teilweise kondensiert. Die Hydrolyse- und/oder Kondensationsreaktionen führen zur Bildung von Verbindungen oder Kondensaten mit Hydroxy-, Oxogruppen und/oder Oxobrücken, die als Vorstufen dienen. Es können stöchiometrische Wassermengen, aber auch geringere oder größere Mengen verwendet werden. Das sich bildende Sol kann durch geeignete Parameter, z.B. Kondensationsgrad, Lösungsmittel oder pH-Wert, auf die für die Beschichtungszusammensetzung gewünschte Viskosität eingestellt werden. Weitere Einzelheiten des Sol-Gel-Verfahrens sind z.B. bei C.J. Brinker, G.W. Scherer: "Sol-Gel Science - The Physics and Chemistry of Sol-Gel-Processing", Academic Press, Boston, San Diego, New York, Sydney (1990) beschrieben.

Nach dem bevorzugten Sol-Gel-Verfahren werden die Oxide, Hydrolysate oder (Poly)Kondensate durch Hydrolyse und/oder Kondensation aus hydrolysierbaren Verbindungen der oben genannten glas- oder keramikbildenden Elemente erhalten, die gegebenenfalls zur Herstellung des organisch-modifizierten anorganischen Hybridmaterials zusätzlich nicht hydrolysierbare organische Substituenten tragen.

Anorganische Sole werden dabei nach dem Sol-Gel-Verfahren insbesondere aus hydrolysierbaren Verbindungen der allgemeine Formeln MXₙ gebildet, worin M das vorstehend definierte glas- oder keramikbildende Element ist, X wie in nachstehender Formel (I) definiert ist, wobei zwei Gruppen X durch eine Oxogruppe ersetzt sein können, und n der Wertigkeit des Elements entspricht und meist 3 oder 4 ist. Bevorzugt handelt es sich um hydrolysierbare Si-Verbindungen, insbesondere der nachstehenden Formel (I).

Beispiele für einsetzbare hydrolysierbare Verbindungen von Elementen M, die von Si verschieden sind, sind Al(OCH₃)₃, Al(OC₂H₅)₃, Al(O-n-C₃H₇)₃, Al(O-i-C₃H₇)₃, Al(O-n-C₄H₉)₃, Al(O-sek.-C₄H₉)₃, AlCl₃, AlCl(OH)₂, Al(OC₂H₄OC₄H₉)₃, TiCl₄, Ti(OC₂H₅)₄, Ti-(O-n-C₃H₇)₄, Ti(O-i-C₃H₇)₄, Ti(OC₄H₉)₄, Ti(2-ethylhexoxy)₄, ZrCl₄, Zr(OC₂H₅)₄, Zr (O-n-C₃H₇)₄, Zr(O-i-C₃H₇)₄, Zr(OC₄H₉)₄, ZrOCl₂, Zr(2-ethylhexoxy)₄, sowie Zr-Verbindungen, die komplexierende Reste aufweisen, wie z.B. β-Diketon- und (Meth)acrylreste, Natriummethylat, Kaliumacetat, Borsäure, BCl₃, B(OCH₃)₃, B(OC₂H₅)₃, SnCl₄, Sn(OCH₃)₄, Sn(OC₂H₅)₄, VOCl₃ und VO(OCH₃)₃.

Die nachstehenden Ausführungen zum bevorzugten Silizium gelten auch sinngemäß für die anderen Elemente M. Besonders bevorzugt wird das Sol oder das organisch-modifizierte anorganische Hybridmaterial aus einem oder mehreren hydrolysierbaren und kondensierbaren Silanen erhalten, wobei gegebenenfalls mindestens ein Silan einen nicht hydrolysierbaren organischen Rest aufweist. Besonders bevorzugt werden ein oder mehrere Silane mit den folgenden allgemeinen Formeln (I) und/oder (II) verwendet:

SiX₄ (I)

worin die Reste X gleich oder verschieden sind und hydrolysierbare Gruppen oder Hydroxygruppen bedeuten,

RₐSiX₍₄₋ₐ₎ (II)

worin R gleich oder verschieden ist und einen nicht hydrolysierbaren Rest darstellt, der gegebenenfalls eine funktionelle Gruppe aufweist, X die vorstehende Bedeutung hat und a den Wert 1, 2 oder 3, vorzugsweise 1 oder 2, hat.

In den obigen Formeln sind die hydrolysierbaren Gruppen X beispielsweise Wasserstoff oder Halogen (F, Cl, Br oder I), Alkoxy (vorzugsweise C₁₋₆-Alkoxy, wie z.B. Methoxy, Ethoxy, n-Propoxy, i-Propoxy und Butoxy), Aryloxy (vorzugsweise C₆₋₁₀-Aryloxy, wie z.B. Phenoxy), Acyloxy (vorzugsweise C₁₋₆-Acyloxy, wie z.B. Acetoxy oder Propionyloxy), Alkylcarbonyl (vorzugsweise C₂₋₇-Alkylcarbonyl, wie z.B. Acetyl), Amino, Monoalkylamino oder Dialkylamino mit vorzugsweise 1 bis 12, insbesondere 1 bis 6 Kohlenstoffatomen in der bzw. den Alkylgruppe(n).

Der nicht hydrolysierbare Rest R ist beispielsweise Alkyl (vorzugsweise C₁₋₆-Alkyl, wie z.B. Methyl, Ethyl, n-Propyl, Isopropyl, n-Butyl, s-Butyl und t-Butyl, Pentyl, Hexyl oder Cyclohexyl), Alkenyl (vorzugsweise C₂₋₆-Alkenyl, wie z.B. Vinyl, 1-Propenyl, 2-Propenyl und Butenyl), Alkinyl (vorzugsweise C₂₋₆-Alkinyl, wie z.B. Acetylenyl und Propargyl) und Aryl (vorzugsweise C₆₋₁₀-Aryl, wie z.B. Phenyl und Naphthyl).

Die genannten Reste R und X können gegebenenfalls einen oder mehrere übliche Substituenten, wie z.B. Halogen, Ether-, Phosphorsäure-, Sulfonsäure-, Cyano-, Amid-Mercapto-, Thioether- oder Alkoxygruppen, als funktionelle Gruppen aufweisen.

Der Rest R kann eine funktionelle Gruppe enthalten, über die eine Vernetzung möglich ist. Konkrete Beispiele für die funktionellen Gruppen des Restes R sind Epoxy-, Hydroxy-, Amino-, Monoalkylamino-, Dialkylamino-, Carboxy-, Allyl-, Vinyl-, Acryl-, Acryloxy-, Methacryl-, Methacryloxy-, Cyano-, Aldehyd- und Alkylcarbonylgruppen. Diese Gruppen sind vorzugsweise über Alkylen-, Alkenylen- oder Arylen-Brückengruppen, die durch Sauerstoff- oder Schwefelatome oder -NH-Gruppen unterbrochen sein können, an das Siliziumatom gebunden. Die genannten Brückengruppen leiten sich zum Beispiel von den oben genannten Alkyl-, Alkenyl- oder Arylresten ab. Die Brückengruppen der Reste R enthalten vorzugsweise 1 bis 18, insbesondere 1 bis 8 Kohlenstoffatome.

Besonders bevorzugte hydrolysierbare Silane der allgemeinen Formel (I) sind Tetraalkoxysilane, wie Tetramethoxysilan und insbesondere Tetraethoxysilan (TEOS). Durch saure Katalyse erhaltene anorganische Sole, z.B. TEOS-Hydrolysate, sind besonders bevorzugt. Besonders bevorzugte Organosilane der allgemeinen Formel (II) sind Epoxysilane wie 3-Glycidyloxypropyltrimethoxysilan (GPTS), Methacryloxypropyltrimethoxysilan und Acryloxypropyltrimethoxysilan, wobei GPTS-Hydrolysate mit Vorteil eingesetzt werden können.

Sofern ein organisch-modifiziertes anorganisches Hybridmaterial hergestellt wird, können ausschließlich Silane der Formel (II) oder eine Mischung von Silanen der Formel (I) und (II) eingesetzt werden. Bei den anorganischen Solen auf Siliziumbasis werden ausschließlich Silane der Formel (I) verwendet, wobei gegebenenfalls anteilig hydrolysierbare Verbindungen der obigen Formel MXₙ zugegeben werden.

Besonders bevorzugt sind organisch-modifizierte anorganische Hybridmaterialien, welche aus Solen auf Titanbasis hergestellt werden. Es können auch noch Silane der Formel (I) und/oder (II) eingesetzt werden.

Sofern das anorganische Sol aus im Lösungsmittel dispergierten diskreten Oxidteilchen besteht, können sie die Härte der Schicht verbessern. Bei diesen Teilchen handelt es sich insbesondere um nanoskalige anorganische Teilchen. Die Teilchengröße (röntgenographisch ermitteltes Volumenmittel) liegt z.B. im Bereich von unter 200 nm, insbesondere unter 100 nm, bevorzugt unter 50 nm, z.B. 1 nm bis 20 nm.

Erfindungsgemäß können z.B. anorganische Sole von SiO₂, ZurO₂, GeO₂, CeO₂, ZnO, Ta₂O₅, SnO₂ und Al₂O₃ (in allen Modifikationen, insbesondere als Böhmit AlO(OH)), vorzugsweise Sole von SiO₂, Al₂O₃, ZurO₂, GeO₂ sowie Mischungen derselben als nanoskalige Teilchen verwendet werden. Solche Sole sind zum Teil auch im Handel erhältlich, z.B. Kieselsole, wie die Levasile ® der Bayer AG.

Als anorganisches oder organisch modifiziertes anorganisches matrixbildendes Material kann auch eine Kombination von derartigen nanoskaligen Teilchen mit als Hydrolysaten oder (Poly)Kondensaten vorliegenden anorganischen Solen oder organisch-modifizierten Hybridmaterialien verwendet werden, was hier mit Nanokompositen bezeichnet wird.

Gegebenenfalls können auch organische Monomere, Oligomere oder Polymere aller Art als organische matrixbildende Materialien enthalten sein, die als Flexibilisatoren dienen, wobei es sich um übliche organische Bindemittel handeln kann. Diese können zur Verbesserung der Beschichtungsfähigkeit verwendet werden.

In der Regel werden sie nach Fertigstellung der Schicht photokatalytisch abgebaut. Die Oligomere und Polymere können funktionelle Gruppen aufweisen, über die eine Vernetzung möglich ist. Diese Vernetzungsmöglichkeit ist auch gegebenenfalls bei den oben erläuterten organisch modifizierten anorganischen matrixbildenden Materialien möglich. Auch Mischungen anorganischer, organisch modifizierter anorganischer und/oder organischer matrixbildender Materialien sind möglich.

Beispiele für verwendbare organische matrixbildende Materialien sind Polymere und/oder Oligomere, die polare Gruppen, wie Hydroxyl-, primäre, sekundäre oder tertiäre Amino-, Carboxyl- oder Carboxylatgruppen, aufweisen. Typische Beispiele sind Polyvinylalkohol, Polyvinylpyrrolidon, Polyacrylamid, Polyvinylpyridin, Polyallylamin, Polyacrylsäure, Polyvinylacetat, Polymethylmethacrylsäure, Stärke, Gummi arabicum, andere polymere Alkohole wie z.B. Polyethylen-Polyvinylalkohol-Copolymere, Polyethylenglycol, Polypropylenglycol und Poly(4-vinylphenol) bzw. davon abgeleitete Monomere oder Oligomere.

Wie bereits vorstehend erwähnt, sind bei Substraten, die aus einem empfindlichen Material bestehen oder eine Oberflächenschicht (z.B. eine Lackierung oder ein Email) aus einem solchen empfindlichen Material aufweisen, ein unmittelbarer Auftrag nicht oder nur schlecht möglich. Es kann eine Sperrschicht zwischen dem Substrat (gegebenenfalls mit Oberflächenbeschichtung) und der photokatalytischen Schicht angeordnet werden. Hierfür kann eine anorganische Schicht aus einem anorganischen matrixbildenden Material eingesetzt werden. Hierfür können die vorstehend beschriebenen anorganischen Sole verwendet werden.

Es ist auch möglich, eine photokatalytische Schicht mit "eingebauter" Sperrschicht herzustellen, indem ein Konzentrationsgradient von photokatalytisch aktiven Nanostäben in der photokatalytischen Schicht ausgebildet wird. Dies kann beispielsweise durch eine Oberflächenmodifikation der photokatalytisch aktiven Substanz mit hydrophoben Gruppen, insbesondere fluorierte organische Gruppen oder organischen Alkylgruppen geschehen. Verfahren für die Oberflächenmodifikation sind dem Fachmann bekannt.

Das matrixbildende Material kann auch zusätzlich Titandioxid, beispielsweise als amorphes TiO₂, TiO₂-Nanopartikeln oder TiO₂-Nanostäben enthalten. Diese Bestandteile können mit einem Anteil zwischen 10 Gew.-% und 80 Gew.-% bezogen auf die Zusammensetzung des matrixbildenden Materials bei der Herstellung der Initiatorzusammensetzung vorliegen, bevorzugt zwischen 25 Gew.-% und 65 Gew.-%.

Die vorstehend als matrixbildenden Komponenten genannten Verbindungen können auch als für die Vorbehandlung des Substrats bei dem Auftragen und Härten der organisch-anorganischen Beschichtung verwendet werden. Dabei können sowohl Sole eingesetzt werden, als auch eine Lösung einer hydrolysierbaren Metallverbindung aufgetragen werden.

Bevorzugt wird eine Lösung eines Silans der Formel II aufgetragen. Besonders Bevorzugt sind dabei Silane der Formel II, bei denen R eine funktionelle Gruppe enthält, über die eine Vernetzung möglich ist. Konkrete Beispiele für die funktionellen Gruppen des Restes R sind Epoxy-, Hydroxy-, Amino-, Monoalkylamino-, Dialkylamino-, Carboxy-, Allyl-, Vinyl-, Acryl-, Acryloxy-, Methacryl-, Methacryloxy-, Cyano-, Aldehyd- und Alkylcarbonylgruppen. Diese Gruppen sind vorzugsweise über Alkylen-, Alkenylen- oder Arylen-Brückengruppen, die durch Sauerstoff- oder Schwefelatome oder -NH-Gruppen unterbrochen sein können, an das Siliziumatom gebunden. Die genannten Brückengruppen leiten sich zum Beispiel von den oben genannten Alkyl-, Alkenyl- oder Arylresten ab. Die Brückengruppen der Reste R enthalten vorzugsweise 1 bis 18, insbesondere 1 bis 8 Kohlenstoffatome.

Besonders bevorzugte Organosilane sind Epoxysilane wie 3-Glycidyloxypropyltrimethoxysilan (GPTS), Methacryloxypropyltrimethoxysilan (MPTS) und Acryloxypropyltrimethoxysilan.

Die Schicht wird nach dem Auftragen getrocknet und entsprechend ihrer funktionellen Gruppe vernetzt. Dies kann den Zusatz von Vernetzungsinitiatoren erfordern.

Nach dem Verfahren können auch noch weitere Schichten aufgebracht werden, beispielsweise um die beschichtete Oberfläche des Substrats gegen UV-Strahlung zu schützen.

Ein besonderer Vorteil des erfindungsgemäßen Verfahrens liegt darin, dass die verwendeten Zusammensetzungen auf einfache Weise auf die Substrate aufgetragen werden. Dabei ermöglicht die Initiatorschicht mit der photokatalytisch aktiven Substanz die Herstellung von besonders feinen Strukturen in nur wenigen Schritten. Zum Einsatz kommen zu diesem Zweck alle bekannten Druckverfahren, wie der Tintenstrahldruck, der Tiefdruck, der Siebdruck, der Offsetdruck oder der Hoch- und Flexodruck. Oftmals werden für den Druck der elektrischen Funktionalitäten auch Kombinationsdrucke der vorab erwähnten Druckverfahren eingesetzt. Es kann nötig sein, die verwendeten Druckplatten, - walzen oder Stempel an die Eigenschaften der Zusammensetzungen anzupassen, beispielsweise durch Anpassung ihrer Oberflächenenergie.

Bei den durch Strukturierung aufgetragenen Strukturen gibt es eigentlich keine Beschränkung. So können sowohl verbundene Strukturen, wie Leiterbahnen aufgetragen werden. Außerdem ist es möglich auch punktförmige Strukturen aufzutragen. Aufgrund der guten Auflösung ist es mit dem Verfahren möglich, für das Auge nicht sichtbare leitfähige Punkte auf eine Folie aufzutragen. Dies spielt bei der Herstellung von Oberflächen für Touch-Screens eine große Rolle.

Die Strukturierung durch das Aufbringen der Strukturvorlage kann sogar in übliche Druckverfahren integriert werden, indem die Strukturvorlage die Druckvorlage ersetzt.

Die Erfindung betrifft außerdem ein beschichtetes Substrat erhalten nach dem erfindungsgemäßen Verfahren. Ein solches Substrat zeichnet sich durch eine Initiatorschicht aus, welche photokatalytisch aktive Nanostäbe umfasst aus. Diese Schicht weist eine Dicke zwischen 50 nm bis 200 µm auf. Bevorzugte Schichtdicken liegen zwischen 100 nm und 1 µm, bevorzugt 50 nm bis 700 nm. Die Schichtdicke kann aber auch zwischen 20 und 70 µm liegen. Die Schicht kann auch ein Matrixmaterial umfassen, wie bereits für das Verfahren beschrieben. Bevorzugt ist ein organisch-modifiziertes anorganisches Matrixmaterial.

Aus dieser Schicht ist, mindestens in einem Bereich der Oberfläche der Initiatorschicht, eine Metallschicht aufgebracht. Diese Schicht ist nur bis zu 200 nm dick. Bevorzugte Schichtdicken liegen zwischen 20 und 100 nm, bevorzugt 50 bis 100 nm. Als Metall kommen dabei insbesondere Kupfer, Silber, Gold, Nickel, Zink, Aluminium, Titan, Chrom, Mangan, Wolfram, Platin oder Palladium, bevorzugt Silber oder Gold.

Erfindungsgemäß weist die Metallschicht auf der Initiatorschicht eine Strukturierung mit Strukturelementen mit einer Ausdehnung von unter 50 µm auf, bevorzugt unter 10 µm auf.

In einer besonders vorteilhaften Weiterbildung der Erfindung weist das beschichtete Substrat metallische Strukturen auf, welche mindestens teilweise transparent sind. Dies kann beispielsweise durch das Aufbringen von Strukturen mit einer Auflösung von unter 20 µm auf ein transparentes Substrat erreicht werden, bevorzugt unter 10 µm. Es können auch Strukturen mit einer Auflösung von unter 5 µm oder sogar 1 µm sein. Dabei bedeutet Auflösung, dass die Struktur Strukturen mit einer minimalen Ausdehnung von unter der genannten Auflösung aufweist. Es kann sich dabei um metallisierte oder nicht metallisierte Bereiche handeln.

Die beschichteten Substrate, welche mit dem erfindungsgemäßen Verfahren erhalten werden, können für viele Anwendungen eingesetzt werden. Zum einen eignet sich das Verfahren zum Aufbringen von reflektierenden Metallschichten auf Oberflächen. Diese können beispielsweise als reflektierende Schichten in holographischen Anwendungen verwendet werden.

Ein besonderer Vorteil der Erfindung liegt in der Herstellung von leitfähigen Strukturen. Diese eignen sich als Leiterbahnen in elektronischen Anwendungen, in Touch-Screen-Displays, Solarkollektoren, Displays, als RFID-Antenne oder in Transistoren. Sie eignen sich daher als Ersatz in Produkten, welche bisher auf ITO (Indiumzinnoxid) Basis hergestellt wurden, wie beispielsweise in TCO-Beschichtungen (TCO: transparent conductive oxide).

Die Strukturen können aber auch im Bereich von Transistoren eingesetzt werden.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.
- Fig. 1: TEM-Aufnahme von Nanostäben aus TiO₂;
- Fig. 2: Elektronenbeugungsbild der Nanostäbe;
- Fig. 3A: Schematische Darstellung einer Ausführungsform des erfindungsgemäßen Verfahrens (30: Strukturvorlage; 32: Vorläuferzusammensetzung; 34: Initiatorschicht; 36: Substrat; 38 UV-Licht);
- Fig. 3B: Abbildung der verwendeten Stempelvorlage aus PDMS hergestellt über einen Abformungsprozess von einem kommerziell erhältlichen Nickelmaster;
- Fig. 3C: Lichtmikroskopische Aufnahme einer Oberflächenstruktur des unter Fig. 3B dargestellten PDMS-Stempels;
- Fig. 4: Lichtmikroskopische Aufnahme einer hergestellten metallischen Struktur (Auflichtaufnahme). Die hellen Regionen stellen die Silberabscheidungen dar;
- Fig. 5: Lichtmikroskopische Aufnahme einer hergestellten metallischen Struktur (Durchlichtaufnahme). Die dunklen Regionen stellen die Silberabscheidungen dar;
- Fig. 6: Foto eines Versuchsaufbaus zur Demonstration eines Interferenzmusters beim Durchstrahlen einer hergestellten metallischen Struktur mit einem Laser;
- Fig. 7: Lichtmikroskopische Aufnahme (Durchlichtaufnahme) von linienförmigen, metallischen Abscheidung hergestellt unter Verwendung von TiO₂-Nanostäben. Die dunklen Areale zeigen Silberabscheidungen. Der Maßstab entspricht 10 µm;
- Fig. 8: Lichtmikroskopische Aufnahme (Durchlichtaufnahme) von strukturierten, metallischen Abscheidungen hergestellt unter Verwendung von TiO₂-Nanostäben. Dunkle Areale zeigen Silberabscheidungen. Der Maßstab entspricht 10 µm.

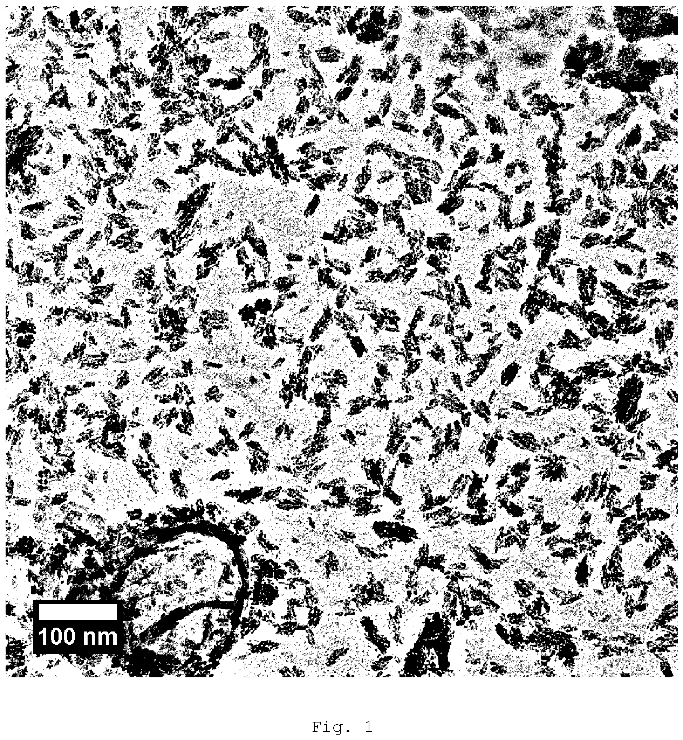

Figur 1 zeigt eine TEM-Aufnahme (Transmissionselektronenmikroskop) von erfindungsgemäßen Nanostäben aus TiO₂. Ihre längliche Ausdehnung ist deutlich zu erkennen.

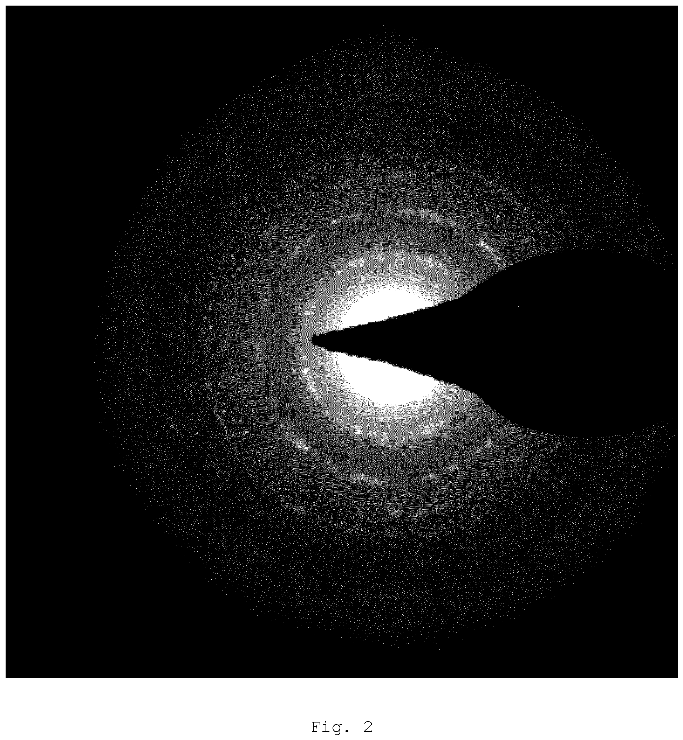

Figur 2 zeigt ein Diffraktogramm von Nanostäben aus TiO₂. Die Reflexe belegen die kristalline Struktur der Nanostäbe.

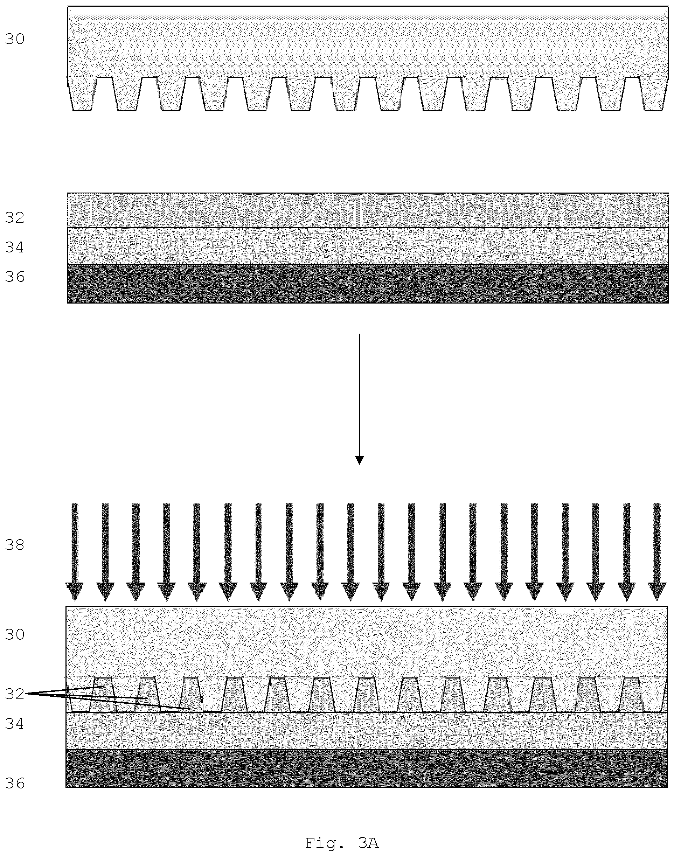

Figur 3A zeigt schematische Darstellung einer Ausführungsform des erfindungsgemäßen Verfahrens. Ein Substrat (36) wird mit einer photokatalytisch aktiven Initiatorschicht (34) beschichtet. Auf diese Schicht wird eine Schicht der Vorläuferzusammensetzung (32) aufgetragen. Auf ein derart beschichtetes Substrat wird eine Strukturvorlage (30) aufgebracht, wobei die Strukturvorlage (30) zumindest teilweise in Kontakt mit der Initiatorschicht (34) gebracht wird. Dadurch kommt es zu einer Verdrängung der Vorläuferzusammensetzung an diesen Stellen. Die Vorläuferverbindung (32) wird in die Vertiefungen der Strukturvorlage (30) verdrängt, welche nicht in Kontakt mit der Initiatorschicht (34) stehen. Dann wird durch die Strukturvorlage hindurch mit UV-Licht (38) belichtet. Dabei kommt es zur Reduktion der Vorläuferverbindung und zur Abscheidung einer metallischen Schicht an den Stellen, an denen die Vorläuferzusammensetzung nicht verdrängt wurde.

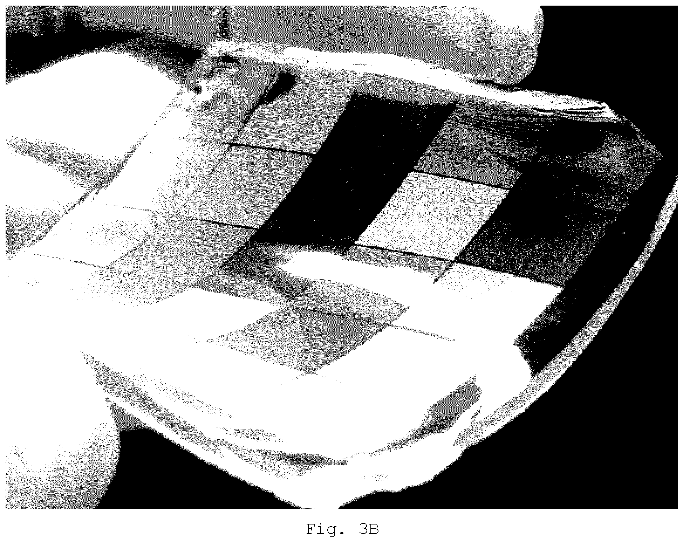

Die Figur 3B zeigt eine in den Beispielen verwendete Stempelvorlage aus PDMS hergestellt über einen Abformungsprozess von einem Nickelmaster. Die Herstellung solcher Stempel gehört zum Fachwissen des Fachmanns.

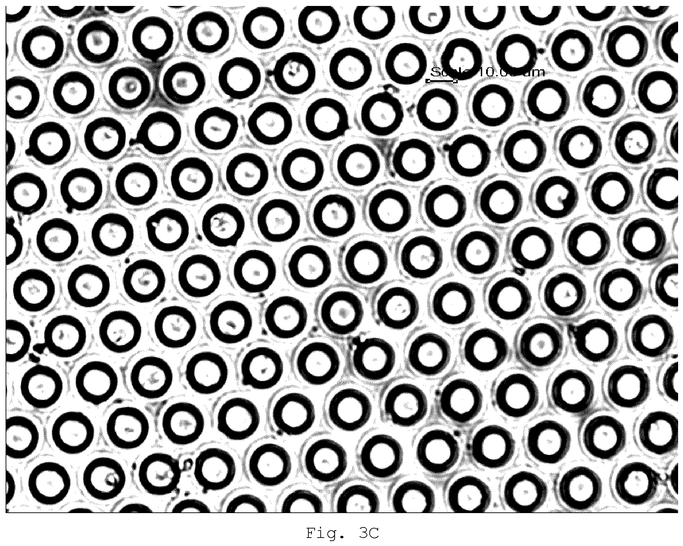

Die Figur 3C zeigt eine lichtmikroskopische Aufnahme einer Oberflächenstruktur des in Figur 3B gezeigten Stempels. Der Stempel weist zylindrische Erhebungen in einem regelmäßigem hexagonalen Raster auf. Die mit dieser Strukturvorlage hergestellten metallischen Strukturen zeigen somit eine regelmäßige Anordnung von kreisrunden nicht beschichteten Bereichen.

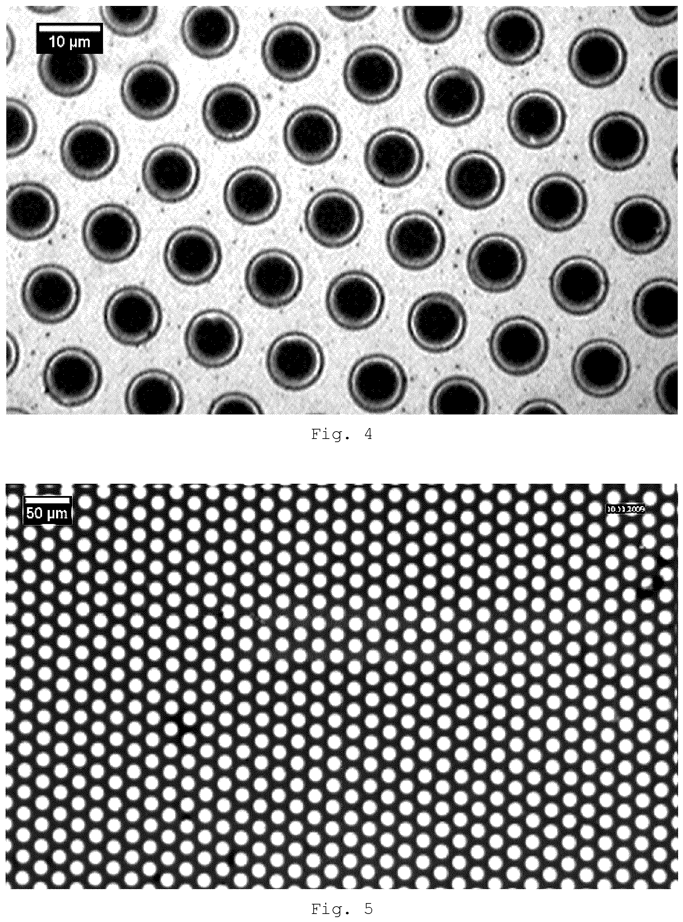

Figur 4 zeigt eine lichtmikroskopische Aufnahme einer mit dem erfindungsgemäßen Verfahren hergestellten metallischen Struktur. Deutlich sind die scharfen abgegrenzten Bereich der Abscheidung der metallischen Strukturen zu erkennen. Die Schärfe der metallischen Struktur zeigt auch, dass mit dem Verfahren noch deutlich feinere Strukturen als die gezeigten Strukturen mit einer Strukturierung von unter 10 µm möglich sind.

Figur 5 zeigt eine lichtmikroskopische Aufnahme einer mit dem erfindungsgemäßen Verfahren hergestellten metallischen Struktur. Dabei wurde in Gegensatz zur Figur 4 eine Strukturvorlage verwendet, welche kreisförmige Noppen aufwies, welche sich als nicht metallisierte Kreise auf der Abbildung zeigen. Auch mit solchen Strukturvorlagen kann eine hohe Auflösung erreicht werden.

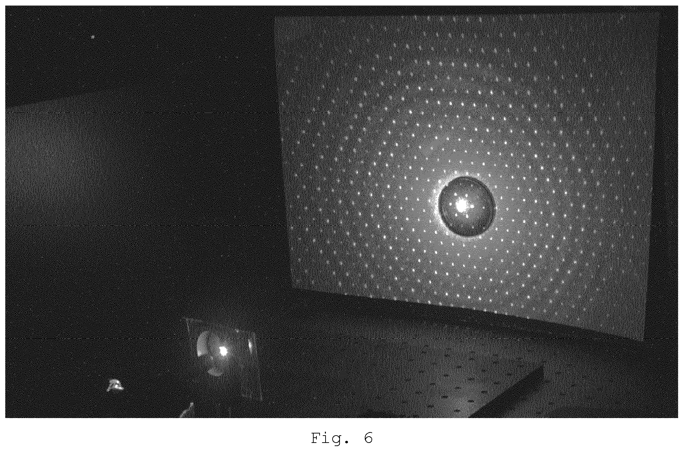

Figur 6 zeigt einen Versuchsaufbau, bei dem die Interferenz einer transparenten erfindungsgemäßen metallischen Struktur gezeigt wird. Dabei wird mit einem Laser durch ein erfindungsgemäß strukturiertes Substrat belichtet. Durch die gleichmäßige Struktur auf der Oberfläche kommt es zu Interferenzerscheinungen, welche auf der in einem bestimmten Abstand aufgestellten Fläche sichtbar sind. Die konzentrischen Ringe sind deutlich zu erkennen. Dabei wurde der Lichtpunkt des Lasers auf der Oberfläche durch einen dort platzierten Filter abgeschwächt, um die Ringe für das Foto sichtbar zu machen. Dieser Versuchsaufbau zeigt zum einen die Transparenz der erhaltenen Beschichtungen und auch die hohe Abbildungstreue bei der Verwendung von regelmäßigen Strukturvorlagen. Nur bei einer sehr hohen Abbildungstreue kommt es zur Interferenz.

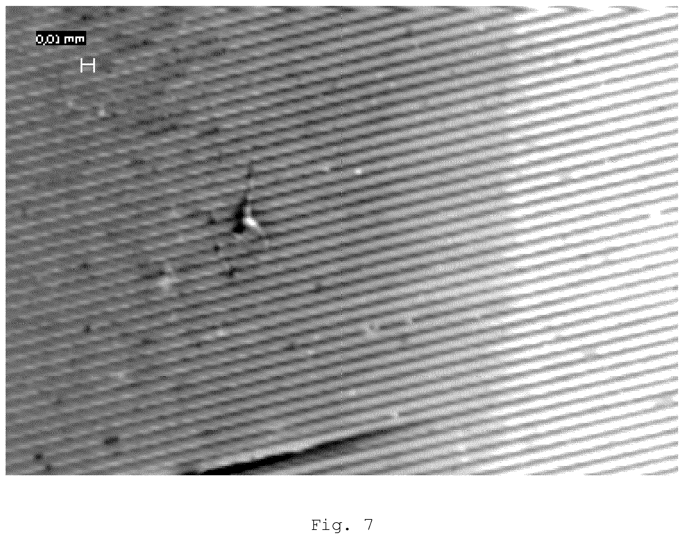

Figur 7 zeigt eine lichtmikroskopische Aufnahme einer linienförmigen metallischen Struktur, welche unter Verwendung eines entsprechenden Stempels hergestellt wurde.

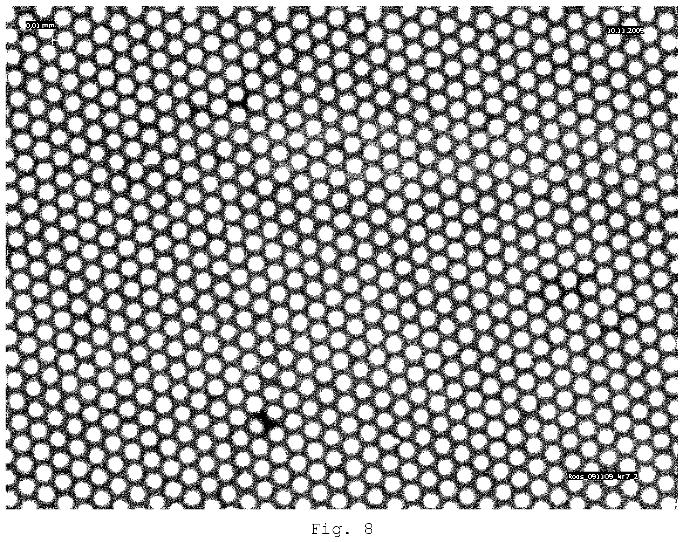

Figur 8 zeigt eine metallische Struktur mit einem kreisförmigem Muster analog zu Figur 5.

Es sind zahlreiche Abwandlungen und Weiterbildungen der beschriebenen Ausführungsbeispiele verwirklichbar.

### Beispiele

### (1) Verwendete Substrate

Als Substrate wurden verschiedene Folien und Gläser verwendet. So wurden als Folien Polyethylenterephthalatfolien oder Polyimidfolien, Polycarbonat- und PMMA-Substrate und als Gläser Natronkalkglas oder Borsilikatglas verwendet. Die Größe der Substrate variierte zwischen 5 cm x 5 cm und 10 cm x 10 cm. Die Dicke der Substrate variierte zwischen 0,075 mm bis 5 mm.

### (2) Herstellung der Nanostäbe

Vorschrift entnommen aus: Jia, Huimin at al., Materials Research Bulletin, 2009, 44, 1312-1316, "Nonaqueous sol-gel synthesis and growth mechanism of single crystalline TiO2 nanorods with high photocatalytic activity".

240 mL Benzylalkohol wurden in einer 500-ml-Schottflasche mit Stabrührmaus vorgelegt. Anschließend wurde "Alles" (Benzylalkohol, Spritze, Titantetrachlorid) in eine Glovebag unter Argon eingeschleust, die Benzylalkoholflasche geöffnet und unter starkem Rühren wurde der Bag 2mal mit Argon gespült (= mit Ar gefüllt und teilweise entleert und erneut befüllt). Mittels 20ml-Spritze und langer Kanüle wurden 12 ml TiCl₄ entnommen, die Kanüle von der Spritze entfernt und unter starkem Rühren tropfenweise zu dem Benzylalkohol gegeben.

Mit jedem zugegebenen Tropfen TiCl₄ ertönte ein Knall- bzw. Knackgeräusch und es war eine starke Rauchentwicklung zu beobachten. Dabei färbte sich die Lösung intensiv rot und erwärmte sich. Nach vollständiger Zugabe war die Lösung intensiv orange-gelb gefärbt und es hatten sich rote Agglomerate gebildet. Der Ansatz wurde noch für ∼ 1 h unter Ar-Atmosphäre mit offenem Deckel rühren gelassen und dann aus dem Glovebag herausgeholt. Die Lösung war nun intensiv gelb gefärbt mit mehreren kleinen und dickeren, weißen/hellen Agglomeraten.

Unter dem Abzug wurde der Ansatz offen dann noch für ∼ 1 h rühren gelassen bis er ohne die dickeren Klumpen in zwei Teflongefäße aufgeteilt (jeweils ∼ 130 g) und autoklaviert wurde (Druckaufschluss: in Block A; Zeit: 2 x 23 h 59 min; Temp.: 80 °C).

Der Überstand in beiden Teflongefäßen wurde mittels Pipette abgenommen, der gelige, weiße Niederschlag aufgeschlämmt und in Zentrifugenröhrchen gefüllt und abzentrifugiert (15 min; mit 2000 RCF; bei RT; Bremsleistung: 0). Das Zentrifugat wurde dekantiert und zu den Rückständen Chloroform gegeben. Die Ansätze wurden über Nacht stehen gelassen.

Die Zentrifugenröhrchen wurden mit Chloroform paarweise austariert, ordentlich geschüttelt bis keine größeren Agglomerate mehr zu sehen waren und abzentrifugiert (15 min; 3000 RCF; RT; Bremsleistung: 0). Das Zentrifugat wurde wieder dekantiert und es wurde erneut Chloroform zu den Rückständen gegeben. Anschließend wurde wie oben beschrieben weiterverfahren (ohne das Stehenlassen über Nacht). Insgesamt wurden die Partikel 3mal mit Chloroform gewaschen.

Nach dem letzten Dekantieren wurden die Zentrifugenröhrchen offen über Nacht unter dem Abzug stehen gelassen und am nächsten Morgen die getrockneten Nanostäbe in ein Rollrandglas umgefüllt.

### (3) Herstellung der Silberkomplex-Lösung

0,1284 g (1,06 mmol) TRIS (Tris(hydroxymethyl)aminomethan) wurde in 0,5 g (27, 75 mmol) deionisiertem H₂O und 0, 5 g (10,85 mmol) EtOH gelöst. Außerdem wurden 0,0845 g (0.5 mmol) AgNO₃ in 0,5 g (27, 75 mmol) deionisiertem H₂O und 0, 5 g (10,85 mmol) EtOH gelöst. Die AgNO₃-Lösung wurde unter Rühren zu der ersten Lösung gegeben. Die gebildete Lösung des Metallkomplexes war farblos und klar. Die Lösung kann auch in reinem deionisiertem Wasser hergestellt werden.

### (4) Lyothermale Synthese von TiO₂-Partikeln (lyo-TiO₂)

48,53 Ti(O-i-Pr)₄ wurden zu 52,73 g 1-PrOH (n-Propanol) gegeben. Zu dieser Lösung wurde langsam eine Lösung aus Salzsäure (37 %, 3,34 g) und 10,00 g 1-PrOH zugetropft. Zu dieser Lösung wurde dann eine Mischung aus 4,02 g H₂O und 20,00 g 1-PrOH getropft. Die erhaltene Lösung ist eventuell leicht gelb gefärbt und wurde in ein Druckaufschlussgefäß gefüllt (ca. 130 g). In diesem Gefäß wurde die Lösung für 2,5 h bei 210 °C behandelt.

Der Ansatz wurde Dekantiert und die erhaltenen Partikel in einen Kolben überführt und das Lösungsmittel bei 40 °C im Rotationsverdampfer bei Unterdruck entfernt.

Die erhaltenen Partikel wurden zur weiteren Verwendung in Wasser suspendiert.

### (5) Allgemeine Anwendung

Die folgenden Schritte wurden für jede Probe durchgeführt. Die Substrate wurden mit Ethanol, Propanol und flusenfreien Tüchern vorgereinigt. Die verschiedenen Suspensionen wurden entweder durch Fluten oder durch Rakeln aufgetragen. Die erhaltenen TiO₂-Schichten wurden in einem Ofen bei Temperaturen zwischen 100 °C und 150 °C, insbesondere bei 120 °C oder 140 °C, für 5 bis 30 Minuten getrocknet. Danach wurden die Substrate mit deionisiertem Wasser gespült, um Rückstände zu entfernen, und mit Druckluft getrocknet.

Danach wurde die Lösung des Silberkomplexes aufgetragen. Auf die Oberfläche wurde die Strukturvorlage aufgebracht, meistens ein Stempel aus PDMS, und mit UV-Strahlung bestrahlt. Danach wurde der überschüssige Silberkomplex durch Spülen mit deionisiertem Wasser entfernt und die beschichteten Substrate mit Druckluft getrocknet. Als Lichtquelle wurde eine Quecksilber-Xenon-Lampe (LOT-Oriel solar simulator, 1000 W, fokussiert auf eine Fläche von 10 cm x 10 cm) verwendet. Die Intensität der Lampe wurde mit dem digitalen Messgerät "UV-Integrator" (BELTRON) gemessen und betrug 55 mW/cm² in dem Spektralbereich von 250 bis 410 nm.

### (6) Suspensionen von TiO₂-Nanostäben in H₂O/EtOH

Zuerst wurden die TiO₂-Nanostäbe in deionisiertem Wasser suspendiert. Danach wurde eine entsprechende Menge an Ethanol hinzugefügt. In allen Suspensionen betrug das Verhältnis an H₂O und EtOH in den Suspensionen H₂O:EtOH → 20:80 in Gew.-% oder 10:90 in Gew.-%. Für die Herstellung von TiO₂-Schichten wurden folgende Suspensionen hergestellt:
- 1,5 Gew.-% TiO₂-Nanostäbe in H₂O/EtOH

### (7) Aufbringen der TiO₂-Schicht auf eine poröse SiO₂-Schicht.

Die Suspension von TiO₂-Nanostäben wurde durch Fluten auf eine poröse SiO₂-Schicht auf Glas aufgebracht. Dafür wurde ein übliches SiO₂-Sol verwendet.

### (8) Herstellung einer Strukturvorlage

### Herstellung eines Prägestempels als Abguss eines Nickelmasters

Im Folgenden wird die Herstellung eines Prägestempels aus PDMS (Silikonkautschuk) als Abguss eines Nickelmasters beschrieben.

### 1. Beschreibung des Nickelmasters und der Gießform

Bei dem Nickelmaster handelt es sich um eine galvanisch hergestellte Nickelfolie der Dimension 100 mm x 100 mm auf die eine Mikrostruktur (regelmäßig angeordnete zylindrische Vertiefungen mit einem Durchmesser von 5 µm, einer Höhe von 10 µm und einem Abstand von 5 µm aufgebracht ist. Diese Nickelfolie wird auf den Boden einer aus Aluminium oder ähnlichem Material hergestellten Gießform aufgeklebt oder mittels ferromagnetischer Klebefolie angebracht. Hierbei ist zu beachten, dass der Nickelmaster absolut plan aufzubringen ist, da sich jegliche Unebenheit im späteren Stempel wiederfinden wird.

Außerdem muss die Gießform auf eine möglichst waagerechte Lage gebracht werden, damit der Prägestempel später eine gleichmäßige Dicke aufweist.

### 2. Mischung des Silikonkautschuks und Formabguss

Man gibt beide Komponenten des PDMS (z. B. Sylgard 184 von Dow Corning) im entsprechenden Verhältnis (z.B. 10:1) zusammen und mischt beide Komponenten durch Rühren. Die anzusetzende Menge richtet sich nach der gewünschten Dicke des Prägestempels (typische Stempeldicke: 2 bis 4 mm). Das Mischgefäß sollte das 3fache Volumen der Mischung umfassen, um ein Überlaufen beim folgenden Entgasungsvorgang zu verhindern.

Zum Entfernen der beim Rühren eingemischten Luftbläschen bringt man die Mischung in einen Vakuumtrockenschrank (bei Raumtemperatur) und evakuiert so lange, bis sämtliche Luftblasen entfernt sind.

Die entgaste PDMS-Mischung gießt man nun in die Gießform und lässt die Mischung härten. In den meisten Fällen ist es sinnvoll, die Härtung durch eine Temperierung der Gießform zu beschleunigen. Typischerweise führt eine Erwärmung der Giesform auf 70°C über eine Stunde zu einem vollständigen Aushärten des PDMS.

### 3. Entformungsvorgang

Das Entformen des PDMS-Stempels geschieht, indem man mit einem Skalpell oder anderem scharfen Messer das PDMS von der senkrechten Wandung der Gießform über den ganzen Umfang einschneidet und dann mit einem flachen und stumpfen Werkzeug (z. B. flacher Spatel) vom Rand abhebelt und dann vorsichtig vom Nickelmaster ablöst.

Unregelmäßigkeiten am Rand können nun mit einem scharfen Messer (z. B. Teppichmesser) abgeschnitten werden.

Grund für die Verwendung von PDMS als Stempelmaterial ist die Transparenz dieses Materials für UV-Licht, welches für die photochemisch realisierte Metallisierung genutzt wird. In diesem Sinne ist auch jedes weitere Material als Stempelmaterial geeignet welches den Anforderungen der UV-Transparenz und Entformbarkeit gemäß Punkt 3. des oben genannten Beispiels der Herstellung des Prägestempels als Abguss eines Nickelmasters genügt.

### (9) Herstellung von Silber-Mikrostrukturen

Die Substrate (z. B. Glas, PMMA, PET, PVC, PS, ...) wurden mit TiO₂-Nanostäben beschichtet. Es wurde eine transparente Beschichtung erhalten. Danach wurde die beschichtete Oberfläche mit der Lösung mit dem Silberkomplex benetzt. Auf das Substrat wurde ein PDMS-Stempel (Polydimethyldisiloxan) aufgedrückt. Dabei verdrängen die Erhöhungen des Stempels and den Stellen, welche in Kontakt mit der photokatalytischen Schicht kommen, dort die Lösung mit dem Silberkomplex. Das Substrat wurde danach durch den transparenten Stempel für 20 s bis 2 Minuten mit UV-Licht (z.B. LOT-Oriel solar simulator, 1000 W Hg(Xe)-Lichtquelle, fokussiert auf einer Fläche von 10x10 cm²) bestrahlt. Der Stempel wurde entfernt und der überschüssige Silberkomplex durch Waschen entfernt. Danach wurden die Substrate getrocknet. Es kann auch eine thermische Nachbehandlung, beispielsweise bei Temperaturen zwischen 50 °C und 200 °C erfolgen. Gegebenenfalls wurde eine weitere Schutzschicht aufgebracht oder auflaminiert. Mit diesem Prozess wurden Strukturen mit einer Auflösung von bis zu 1 µm erhalten.

Für die in den Figuren gezeigten metallischen Strukturen wurde eine TiO₂-Schicht von Nanostäben als Suspension ohne Bindersystem in einer Dicke von ca. 60 nm aufgetragen und eine Lösung des Silberkomplexes aufgetragen. Nach Aufbringen eines entsprechend geformten PDMS-Stempels wurde 20 s bis 60 s belichtet. Der Stempel wies eine Tiefe der Struktur von < 10 µm auf, was dann ungefähr der Dicke der Schicht der Lösung des Silberkomplexes während der Belichtung entspricht.

Das Verfahren ermöglicht es, mit nur zwei Beschichtungszusammensetzungen auf einfache Weise metallische Strukturen zu erzeugen.

### (10) Herstellung von metallischen Strukturen mit PDMS-Stempel

1. Ein mit Initiator beschichtetes Substrat gemäß (5) wird unter die Belichtungseinheit gelegt und mit der Suspension der Vorläuferzusammensetzung wie in Beispiel (5) beschrieben, benetzt (überschichtet).
2. Ein PDMS Prägestempel, hergestellt wie in (8) beschrieben wird nun auf einer Seite im 45° Winkel auf das benetzte Substrat gebracht und langsam abgelegt, bis er vollständig plan auf dem Substrat aufliegt. Dies dient dazu, mögliche Lufteinschlüsse zu vermeiden, welche sich nachteilig auf die Güte (Qualität) der strukturierten Metallisierung auswirken könnten.
3. Der Prägestempel wird nun flächig derart beschwert, dass der Strahlengang durch selbigen für die spätere Belichtung der Initiatorschicht frei bleibt. Dies wird realisiert, indem eine UV-transparente Quarzglasscheibe welche in ihren Ausmaßen größer ist als der Prägestempel, flächig auf selbigen gelegt wird. Darauf wird ein Rahmen aus beliebigem Material gelegt, welcher den Strahlengang durch den PDMS Stempel frei lässt und einzig dazu dient, die Quarzglasscheibe und damit auch den Stempel zu beschweren. Ziel dieses Verfahrens ist es, die Suspension der Vorläuferzusammensetzung unter den erhabenen Bereichen des strukturierten Stempels zwischen selbigem und dem mit Initiatorschicht beschichteten Substrat vollständig zu verdrängen. Der minimale dazu notwendige Druck hängt von der Strukturart und -große des Stempels ab und wird empirisch für jeden eingesetzten Stempel bestimmt. Der maximale Druck der ausgeübt werden darf ohne dass die Qualität des Metallisierungsergebnisses negativ beeinträchtigt wird, wird zunächst ebenfalls empirisch ermittelt. Dieser hängt neben der Strukturart und -große auch durch die Verformbarkeit des Stempelmaterials vom Aspektverhältnis der Strukturen ab. Eine negative Beeinträchtigung des Metallisierungsergebnisses im Sinne der Anmeldung ist die Verringerung der Auflösung oder Veränderung der Form der metallischen Strukturen durch plastische Deformation des Stempels oder auch eine geringere resultierende Dicke der metallischen Schicht durch Verdrängung der Suspension der Vorläuferzusammensetzung aus den nicht erhabenen Bereichen (gleichbedeutend mit Zwischenräumen) des Prägestempels.
4. Die Initiatorschicht wird nun durch die UV-transparente Quarzglasschicht, den UV-transparenten Prägestempel und die UV-transparente Suspension der Vorläuferzusammensetzung hindurch bestrahlt wie in (5) beschrieben.
5. Nach hinreichender Bestrahlungsdauer wird der Strahlengang an der Lichtquelle mittels eines Shutters unterbrochen, und gleichzeitig oder nacheinander der beschwerende Rahmen, die Quarzglasscheibe und der Prägestempel vom Substrat entfernt und dieses wie in (9) beschrieben abgespült und getrocknet und gegebenenfalls thermisch nachbehandelt wie in (9) beschrieben.
6. Alternativ zu Punkt 1. des Beispiels kann der Stempel auch zuerst wie in Punkt 2. dieses Beispiels beschrieben auf das jedoch unbenetzte Substrat aufgebracht und wie unter Punkt 3. beschrieben, beschwert werden. Anschließend wird solange am Rand des Stempels an beliebig vielen Stellen solange die Suspension der Vorläuferzusammensetzung auf das Substrat aufgetragen, bis die Zwischenräume zwischen Stempel und Substrat aufgrund der Kapillarkräfte vollständig mit selbiger Suspension gefüllt sind und die Luft daraus entfernt ist. Hierzu kann es notwendig oder von Vorteil sein, das Substrat samt Stempel, Quarzglas und Rahmen zu kippen.

Anschließend wird gemäß den Punkten 4. und 5. dieses Beispiels weiter verfahren.

### Bezugszeichen

- 30: Strukturvorlage
- 32: Vorläuferzusammensetzung
- 34: Initiatorschicht
- 36: Substrat
- 38: UV-Licht

### zitierte Literatur

US 5,534,312
US 2004/0026258 A1
US 2005/0023957 A1
US 2006/0144713 A1
Noh, C.-, et al., Advances in Resist Technology and Processing XXII, Proceedings of SPIE, 2005, 5753, 879-886, "A novel patterning method of low-resistivity metals".
Noh, C.-, et al., Chemistry Letters, 2005, 34(1), 82-83, "A novel patterning method of low-resistivity metals".
US 2009/0269510 A1
Jia, Huimin at al., Materials Research Bulletin, 2009, 44, 1312-1316, "Nonaqueous sol-gel synthesis and growth mechanism of single crystalline TiO2 nanorods with high photocatalytic activity".

## Patentansprüche

1. Verfahren zur Herstellung von metallischen Strukturen umfassend die folgenden Schritte:
(a) Auftragen einer Initiatorzusammensetzung auf ein Substrat, wobei die Zusammensetzung als Initiator eine photokatalytisch aktive anorganische Substanz in Form von Nanostäben mit einem Durchmesser von unter 100 nm und einer Länge von unter 500 nm umfasst, unter Bildung einer Initiatorschicht;
(b) Auftragen einer Vorläuferzusammensetzung umfassend eine Vorläuferverbindung für eine Metallschicht auf das Substrat;
(c) Aufbringen einer Strukturvorlage auf die Initiatorschicht unter teilweiser Verdrängung der Vorläuferzusammensetzung;
(d) Reduktion der Vorläuferverbindung zum Metall durch Einwirkung von elektromagnetischer Strahlung auf den Initiator;
(e) Entfernung der Strukturvorlage nach der Bestrahlung.

2. Verfahren nach Anspruch 1, **dadurch gekennzeichnet, dass**
die photokatalytisch aktive anorganische Substanz TiO₂ oder ZnO ist.

3. Verfahren nach Anspruch 2, **dadurch gekennzeichnet, dass**
die photokatalytisch aktive Substanz TiO₂ ist.

4. Verfahren nach einem der vorhergehenden Ansprüche, **dadurch gekennzeichnet, dass**
die Strukturvorlage Strukturen mit einer minimalen lateralen Ausdehnung von unter 50 µm beinhaltet.

5. Verfahren nach einem der vorhergehenden Ansprüche, **dadurch gekennzeichnet, dass**
die Vorläuferverbindung ein Silber- Gold oder Kupferkomplex ist.

6. Verfahren nach einem der vorhergehenden Ansprüche, **dadurch gekennzeichnet, dass**
vor dem Auftragen der Initiatorzusammensetzung die Oberfläche des Substrats vorbehandelt wird, wobei die Vorbehandlung eine Plasmabehandlung, Koronabehandlung, Flammenbehandlung und/oder das Auftragen und Härten einer organisch-anorganischen Beschichtung umfasst.

7. Verfahren nach einem der vorhergehenden Ansprüche, **dadurch gekennzeichnet, dass**
die Initiatorzusammensetzung eine matrixbildende Komponente umfasst.

8. Verfahren zur Herstellung von metallischen Strukturen umfassend die folgenden Schritte:(a) Auftragen einer Initiatorzusammensetzung auf ein Substrat, wobei die Zusammensetzung als Initiator eine photokatalytisch aktive anorganische Substanz in Form von Nanostäben mit einem Durchmesser von unter 100 nm und einer Länge von unter 500 nm umfasst, unter Bildung einer Initiatorschicht; (b) Aufbringen einer Vorläuferzusammensetzung umfassend eine Vorläuferverbindung für eine Metallschicht auf eine Strukturvorlage; (c) Aufbringen der Vorläuferzusammensetung zusammen mit der Strukturvorlage auf die Initiatorschicht unter teilweiser Verdrängung der Vorläuferzusammensetzung;(d) Reduktion der Vorläuferverbindung zum Metall durch Einwirkung von elektromagnetischer Strahlung auf den Initiator;(e) Entfernung der Strukturvorlage nach der Bestrahlung.

9. Beschichtetes Substrat, **dadurch gekennzeichnet, dass**
es eine Initiatorschicht und mindestens in einem Bereich der Oberfläche der Initiatorschicht eine darauf angeordnete Metallschicht aufweist, wobei die Initiatorschicht photokatalytische Nanostäbe mit einem Durchmesser von unter 100 nm und einer Länge von unter 500 nm umfasst, wobei die Initiatorschicht eine Dicke zwischen 50 nm und 200 µm und die Metallschicht eine Schichtdicke von bis zu 200 nm aufweisen, und wobei die Metallschicht auf der Initiatorschicht eine Strukturierung mit Strukturelementen mit einer Ausdehnung von unter 50 µm aufweist.

10. Beschichtetes Substrat nach Anspruch 9, **dadurch gekennzeichnet, dass**
das beschichtete Substrat und die metallischen Strukturen mindestens teilweise transparent erscheinen.

11. Verwendung eines Substrats nach einem der Ansprüche 9 oder 10 als Leiterbahn in elektronischen Anwendungen, in Touch-Screen-Displays, in Solarkollektoren, in Displays, als RFID-Antenne, oder in Transistoren.

## Claims

1. Process for producing metallic structures, comprising the following steps:
(a) applying an initiator composition to a substrate, the composition comprising a photocatalytically active inorganic substance in the form of nanorods having a diameter of less than 100 nm and a length of less than 500 nm as an initiator, to form an initiator layer;
(b) applying a precursor composition comprising a precursor compound for a metal layer to the substrate;
(c) applying a structure template to the initiator layer with partial displacement of the precursor composition;
(d) reducing the precursor compound to the metal by the action of electromagnetic radiation on the initiator;
(e) removing the structure template after irradiation.

2. Process according to Claim 1, **characterized in that** the photocatalytically active inorganic substance is TiO₂ or ZnO.

3. Process according to Claim 2, **characterized in that** the photocatalytically active substance is TiO₂.

4. Process according to any of the preceding claims, **characterized in that**
the structure template includes structures having a minimum lateral dimension of less than 50 µm.

5. Process according to any of the preceding claims, **characterized in that**
the precursor compound is a silver, gold or copper complex.

6. Process according to any of the preceding claims, **characterized in that**
the application of the initiator composition is preceded by pretreatment of the surface of the substrate, said pretreatment comprising a plasma treatment, corona treatment, flame treatment and/or the application and curing of an organic-inorganic coating.

7. Process according to any of the preceding claims, **characterized in that**
the initiator composition comprises a matrix-forming component.

8. Process for producing metallic structures, comprising the following steps:
(a) applying an initiator composition to a substrate, the composition comprising a photocatalytically active inorganic substance in the form of nanorods having a diameter of less than 100 nm and a length of less than 500 nm as an initiator, to form an initiator layer;
(b) applying a precursor composition comprising a precursor compound for a metal layer to a structure template;
c) applying the precursor composition together with the structure template to the initiator layer with partial displacement of the precursor composition;
(d) reducing the precursor compound to the metal by the action of electromagnetic radiation on the initiator;
(e) removing the structure template after irradiation.

9. Coated substrate **characterized in that** it has an initiator layer and, at least in a region of the surface of the initiator layer, a metal layer disposed thereon, wherein the initiator layer comprises photocatalytic nanorods having a diameter of less than 100 mm and a length of less than 500 nm, wherein the initiator layer has a thickness between 50 nm and 200 µm and the metal layer has a layer thickness of up to 200 nm, and wherein the metal layer on the initiator layer has structuring with structural elements having an extent of less than 50 µm.

10. Coated substrate according to Claim 9, **characterized in that**
the coated substrate and the metallic structures have an at least partly transparent appearance.

11. Use of a substrate according to either of Claims 9 and 10 as a conductor track in electronic applications, in touchscreen displays, in solar collectors, in displays, as an RFID antenna or in transistors.

## Revendications

1. Procédé pour la fabrication de structures métalliques, comprenant les étapes suivantes :
(a) application d'une composition d'initiateur sur un substrat, la composition comprenant, comme initiateur, une substance inorganique photocatalytiquement active sous forme de nanotubes présentant un diamètre inférieur à 100 nm et une longueur inférieure à 500 nm, avec formation d'une couche d'initiateur ;
(b) application d'une composition de précurseur comprenant un composé précurseur pour une couche métallique sur le substrat ;
(c) application d'un modèle de structure sur la couche d'initiateur avec déplacement partiel de la composition de précurseur ;
(d) réduction du composé précurseur en métal par action d'un rayonnement électromagnétique sur l'initiateur ;
(e) élimination du modèle de structure après l'irradiation.

2. Procédé selon la revendication 1, **caractérisé en ce que** la substance inorganique photocatalytiquement active est le TiO₂ ou le ZnO.

3. Procédé selon la revendication 2, **caractérisé en ce que** la substance inorganique photocatalytiquement active est le TiO2.

4. Procédé selon l'une quelconque des revendications précédentes, **caractérisé en ce que** le modèle de structure comporte des structures présentant une dimension latérale minimale inférieure à 50 µm.

5. Procédé selon l'une quelconque des revendications précédentes, **caractérisé en ce que** le composé précurseur est un complexe d'argent, d'or ou de cuivre.

6. Procédé selon l'une quelconque des revendications précédentes, **caractérisé en ce qu'**avant l'application de la composition d'initiateur, la surface du substrat est prétraitée, le prétraitement comprenant un traitement au plasma, un traitement corona, un traitement à la flamme et/ou l'application et le durcissement d'un revêtement organique-inorganique.

7. Procédé selon l'une quelconque des revendications précédentes, **caractérisé en ce que** la composition d'initiateur comprend un composant formant une matrice.

8. Procédé pour la fabrication de structures métalliques, comprenant les étapes suivantes :
(a) application d'une composition d'initiateur sur un substrat, la composition comprenant, comme initiateur, une substance inorganique photocatalytiquement active sous forme de nanotubes présentant un diamètre inférieur à 100 nm et une longueur inférieure à 500 nm, avec formation d'une couche d'initiateur ;
(b) application d'une composition de précurseur comprenant un composé précurseur pour une couche métallique sur un modèle de structure ;
(c) application de la composition de précurseur ensemble avec le modèle de structure sur la couche d'initiateur avec déplacement partiel de la composition de précurseur ;
(d) réduction du composé précurseur en métal par action d'un rayonnement électromagnétique sur l'initiateur ;
(e) élimination du modèle de structure après l'irradiation.

9. Substrat revêtu, **caractérisé en ce qu'**il présente une couche d'initiateur et, au moins dans une zone de la surface de la couche d'initiateur, une couche métallique disposée sur celle-ci, la couche d'initiateur comprenant des nanotubes photocatalytiques présentant un diamètre inférieur à 100 nm et une longueur inférieure à 500 nm, la couche d'initiateur présentant une épaisseur entre 50 nm et 200 µm et la couche métallique présentant une épaisseur de couche de jusqu'à 200 nm et la couche métallique sur la couche d'initiateur présentant une structuration pourvue d'éléments structuraux d'une extension inférieure à 50 µm.

10. Substrat revêtu selon la revendication 9, **caractérisé en ce que** le substrat revêtu et les structures métalliques présentent un aspect au moins partiellement transparent.

11. Utilisation d'un substrat selon l'une quelconque des revendications 9 ou 10 comme piste conductrice dans des applications électroniques, dans des affichages à écran tactile, dans des collecteurs solaires, dans des affichages, en tant qu'antenne RFID ou dans des transistors.
